# EUROPEAN PATENT APPLICATION

(11) **EP 2 835 452 A1**
(43) Date of publication of application: **11.02.2015**
(21) Application number: 14782930.3
(22) Date of filing: 25.03.2014
(51) Int. Cl.: C30B 29/06, C03B 20/00, C30B 15/10

(54) **SILICA VESSEL FOR PULLING UP SINGLE CRYSTAL SILICON AND PROCESS FOR PRODUCING SAME**

(30) Priority: 08.04.2013 JP 2013080812; 15.04.2013 JP 2013085130
(71) Applicant: Shin-Etsu Quartz Products Co., Ltd., Shinjuku-ku Tokyo 160-0023 (JP)
(72) Inventor: YAMAGATA, Shigeru, Tokyo 160-0023 (JP)
(74) Representative: Wibbelmann, Jobst
(86) International application number: PCT/JP2014/001681
(87) International publication number: WO 2014/167788

(57) **Abstract**

The present invention provides a silica container for pulling single crystal, the container having a straight body portion, a curved portion, and a bottom portion, wherein an outer side of the container is made of opaque silica glass containing bubbles, and an inner side of the container is made of transparent silica glass, and a mixed silica layer in which a phase in which a crystalline silica powder is fused and a phase in which an amorphous silica powder is fused are mixed in a granular texture is provided on at least an inner surface layer portion of the straight body portion. As a result, there is provided the silica container for pulling single crystal silicon which can suppress melt surface vibration of a silicon melt in the silica container at a high temperature.

## Description

### TECHNICAL FIELD

The present invention relates to a silica container for pulling single crystal silicon and a manufacturing method thereof.

### BACKGROUND ART

As methods for manufacturing a silica crucible for pulling a single crystal silicon, such manufacturing methods as described in Patent Literature 1 and Patent Literature 2 have been conventionally used. These methods are methods for putting a quartz powder subjected to purity raising processing into a rotating mold, performing molding, then pushing electrodes thereinto from above, applying voltage to the electrodes to cause arc discharge, increasing an atmospheric temperature to a melting temperature range of the quartz powder (which is assumed to be approximately 1800 to 2100°C), and thereby melting and sintering the quartz powder. However, at the time of using the thus manufactured silica crucible, there arises such a problem of quality of single crystal silicon as that molten silicon and the silica crucible react with each other to produce a silicon monoxide (SiO) gas, this gas is taken as bubbles (gaseous bubbles) into single crystal silicon, and a void defect called a void or a pin hole is generated.

In the CZ method (the Czochralski method) that is a general method for pulling single crystal silicon in particular, a seed crystal is put onto a surface of the melt (which will be also simply referred to as a "melt surface" hereinafter) in a silica container called a crucible (seeding), then the seed crystal is grown while slightly narrowing a diameter thereof (necking), subsequently large-diameter single crystal silicon is formed while increasing the diameter (shouldering), then the large-diameter single crystal silicon is pulled while maintaining the diameter thereof constant (pulling), and the single crystal silicon having a longitudinal shape is taken out. At the time of pulling, a phenomenon that the melt surface of the molten silicon vibrates occurs (this phenomenon may be simply referred to as "melt surface vibration" hereinafter). When this melt surface vibration occurs, there occurs a problem that the seeding, the necking, or the shouldering cannot be performed or that part of the single crystal silicon is polycrystallized during the pulling up (the pulling). As one cause of this phenomenon, the melt surface vibration due to generation of a silicon oxide (SiO) gas has been considered. In the silica crucible produced in Patent Literature 1 or 2, if this silica crucible is a large container having a diameter of 30 inches (75 cm) to 54 inches (135 cm) configured to pull large-diameter single crystal silicon having a diameter of 12 inches (30 cm) to 18 inches (45 cm) in particular, the melt surface vibration highly frequently occurs, and hence immediate solutions have been demanded. The silica crucible and the quartz crucible are synonyms hereinafter. The silica glass and the quartz glass are also synonyms.

Patent Literature 3 discloses that, for example, as a quartz glass crucible in which the melt surface vibration of molten silicon does not occur, an IR (infrared) transmittance of a wall of the crucible is set to 3 to 30%. However, even if a large-sized quartz glass crucible having physical properties in such a wide transmittance range is used, the melt surface vibration cannot be suppressed at the time of pulling the large-diameter single crystal silicon.

In Patent Literature 4, as a method for producing a quartz glass crucible in which melt surface vibration of molten silicon does not occur, introducing water vapor into an atmosphere inside the crucible at the time of manufacturing the crucible is disclosed, and increasing OH group concentration in the entire inner surface layer of the crucible is preferable for suppressing the melt surface vibration. However, even if a large-sized quartz glass crucible according to such a manufacturing method is used, an effect of suppressing the melt surface vibration at the time of pulling large-diameter single crystal silicon is insufficient. Further, erosion (etching) caused by a silicon melt inside the crucible is intensive, and a life span of the crucible is short.

Patent Literature 5 discloses that, in a quartz glass crucible at the time of pulling single crystal silicon, melt surface vibration can be avoided by using natural quartz glass for a belt-like portion alone on a surface in the quartz glass crucible near a melt surface of molten silicon. However, this crucible has relatively less melt surface vibration than a crucible completely made of synthetic quartz glass, and an effect of suppressing the melt surface vibration at the time of pulling large-diameter single crystal silicon is insufficient.

Patent Literature 6 discloses that melt surface vibration can be prevented by distributing a portion having high bubble content in a belt-like pattern on a surface in a quartz glass crucible near a melt surface of molten silicon. However, in this crucible, a certain level of a melt surface vibration suppressing effect can be recognized, but an amount of erosion (etching) caused by the molten silicon in the belt-like portion having the high bubble content is large, and a life span of the crucible is short. Furthermore, a probability that bubbles contained in the belt-like portion are taken into single crystal silicon is high, there often occurs a problem that void defects called voids or pin holes are produced in the single crystal silicon.

Patent Literature 7 discloses that melt surface vibration of molten silicon can be avoided by homogenizing bubble content, a wall thickness, and a transmittance of a quartz glass crucible having rotation axis symmetry over a circumference. It is considered that highly accurately producing various physical properties of the crucible to be symmetrical about a rotation axis over the circumference is basically important in terms of prevention of the melt surface vibration. However, even if the physical properties fluctuate to some extent, prevention of the melt surface vibration has been demanded.

Patent Literature 8 discloses that melt surface vibration can be prevented by providing a plurality of fine concave portions on an inner surface of a quartz glass crucible near a melt surface of molten silicon and also providing a plurality of bubbles below these concave portions. However, in this crucible, the early melt surface vibration in manufacture of single crystal silicon can be suppressed, there occurs a problem that the vibration can again occur after the fine concave portions are solved. In particular, in case of pulling a plurality of ingots of single crystal silicon (multi-pulling), the melt surface vibration at the time of manufacturing second and subsequent ingots become intensive in some cases.

Patent Literature 9 discloses that a roughened surface region is fabricated into a belt-like shape by performing a sandblast treatment using quartz powder with respect to an inner surface of a quartz glass crucible, thereby preventing melt surface vibration. However, in such a crucible, the early melt surface vibration at the time of manufacturing single crystal silicon can be suppressed, but its effect does not last long. Further, it is difficult to perform multi-pulling by using one crucible.

Patent Literature 10 discloses that melt surface vibration can be prevented by fusing a silica powder on an inner surface of a quartz crucible by using oxyhydrogen flames and depositing a silica glass layer containing 500 to 1500 ppm of an OH group. However, according to this manufacturing method, not only processes are complicated to result in an increase in cost but also an amount of etching using a silicon melt near the melt surface is large, and hence there is produced a drawback that the melt surface vibration gradually becomes intensive or a life span of the crucible becomes short.

### CITATION LIST

### PATENT LITERATURES

Patent Literature 1: Japanese Examined Patent Application Publication No. H4-22861
Patent Literature 2: Japanese Examined Patent Application Publication No. H7-29871
Patent Literature 3: Japanese Unexamined Patent Application Publication No. 2000-219593
Patent Literature 4: Japanese Unexamined Patent Application Publication No. 2001-348240
Patent Literature 5: Japanese Patent No. 4338990
Patent Literature 6: Japanese Patent No. 4390461
Patent Literature 7: Japanese Unexamined Patent Application Publication No. 2010-30884
Patent Literature 8: Japanese Unexamined Patent Application Publication No. 2011-105552
Patent Literature 9: International Publication No. WO 2011/158712
Patent Literature 10: Japanese Unexamined Patent Application Publication No. 2012-17240

### SUMMARY OF INVENTION

### TECHNICAL PROBLEM

In view of the above-described problems, it is an object of the present invention to provide a silica container for pulling single crystal silicon which can suppress melt surface vibration of a silicon melt in the silicon container at a high temperature and to provide a method for manufacturing such a silica container.

Furthermore, it is also an object of the present invention to provide a silica container for pulling single crystal silicon which can suppress melt surface vibration of a silicon melt in a silica container at a high temperature and can suppress generation of void defects called voids or pin holes in the single crystal silicon and to provide a method for manufacturing such a silica container.

### SOLUTION TO PROBLEM

To solve the above-described problems, according to the present invention, there is provided a method for manufacturing a silica container for pulling single crystal silicon, the silica container having a straight body portion, a curved portion, and a bottom portion, the method comprising: a step of preparing a crystalline silica powder having a particle size of 10 to 1000 µm as a first raw material powder; a step of preparing a mixed powder of a crystalline silica powder having a particle size of 50 to 2000 µm and an amorphous silica powder having a particle size of 50 to 2000 µm as a second raw material powder; a step of putting the first raw material powder to an inner side of a mold having rotation symmetry, and temporarily molding the first raw material powder into a predetermined shape corresponding to an inner wall of the mold while rotating the mold to form a first temporary compact made of the first raw material powder in the mold; a step of putting the second raw material powder to at least one of an inner side and an upper portion of the first temporary compact formed in the mold to form a second temporary compact having a portion made of the first raw material powder and a portion made of the second raw material powder into a shape corresponding to a shape of a silica container to be manufactured, the second temporary compact having a portion made of the second raw material powder at a position corresponding to at least an inner surface layer portion of the straight body portion of the silica container to be manufactured; and a step of performing heating from an inner side of the second temporary compact based on an electric discharge heating and melting method while rotating the mold to form the portion made of the second raw material powder in the second temporary compact into a mixed silica layer in which a phase in which the crystalline silica powder is fused and a phase in which the amorphous silica powder is fused are mixed in a granular texture, an outer side of the container being made of opaque silica glass containing bubbles, an inner side of the container being made of transparent glass.

According to the method for manufacturing a silica container having such steps, it is possible to manufacture the silica container for pulling single crystal silicon, having the mixed silica layer in which the phase in which the crystalline silica powder is fused and the phase in which the amorphous silica powder is fused are mixed in the granular texture in at least the inner surface layer portion of the straight body portion. The portion where this mixed silica layer is present is etched (eroded) by the silicon melt when the raw material silicon melt is held in the silica container. As regards this etching, the phase in which the amorphous silica powder is fused has a higher rate and a larger etching amount than the phase in which the crystalline silica powder is fused. This difference in etching effect enables forming fine irregularities of the surface of the mixed silica layer (an interface with the raw material silicon melt). Presence of the fine irregularities enables suppressing melt surface vibration of the silicon melt in the silica container at a high temperature. Additionally, even if the etching of the mixed silica layer proceeds due to prolonged use at a high temperature, the fine irregularities continue existing without being annihilated, and hence the melt surface vibration of the silicon melt can be suppressed for a long time.

In this case, it is preferable to form the mixed silica layer to include a position on an inner surface corresponding to a surface of melt on the initial stage when the silica container holds a raw material silicon melt in the inner surface of the silica container to be manufactured.

When the position at which the mixed silica layer is formed is determined as described above, the melt surface vibration of the silicon melt in the initial stage (seeding, necking, shouldering, and others) of the method for pulling single crystal silicon can be suppressed in particular.

Further, it is preferable to form the second temporary compact with the portion made of the second raw material powder at a position corresponding to the inner surface layer portion of the straight body portion and the curved portion of the silica container to be manufactured.

When the second temporary compact is formed in this manner, the mixed silica layer can be formed in the inner surface layer portion of the straight body portion and the curved portion of the silica container. As a result, it is possible to effectively suppress the melt surface vibration of the silicon melt in the initial stage (seeding, necking, shouldering, and others) and subsequent stages (pulling and tailing) of pulling the single crystal silicon.

Furthermore, it is preferable to form the mixed silica layer with a thickness of 2 mm or more in a wall thickness direction of the silica container and a width of 100 mm or more.

When the mixed silica layer having the thickness and the width described above is formed, the melt surface vibration of the raw material silicon melt can be further assuredly suppressed in the manufactured silica container, and its effect can be sustained.

Moreover, in a method for manufacturing a silica container for pulling single crystal silicon according to the present invention, after manufacturing the silica container based on the method according to any one of the methods, it is preferable for the method to comprise a step of forming a high-purity silica glass layer in which concentration of each of impurity elements Li, Na, and K is 50 massppb or less, concentration of each of impurity elements Ca and Mg is 25 massppb or less, and concentration of each of impurity elements Ti, Cr, Fe, Ni, Cu, Zn, Zr, Mo, W, and Pb is 10 massppb or less and which has a thickness of 200 to 2000 µm on at least part of an inner surface where the mixed silica layer is not formed in the inner surface of the silica container.

As described above, when the high-purity silica glass layer is additionally formed in a portion other than the mixed silica layer, impurity elements that are taken into the raw material silicon melt from the inner wall of the silica container at the time of use at a high temperature can be further reduced.

Additionally, in the method for manufacturing a silica container for pulling single crystal silicon according to the present invention, at the step of forming the second temporary compact, the second raw material powder is put to the inner side of the first temporary compact, and the second temporary compact is formed with the portion made of the second raw material powder at a position corresponding to the inner surface layer portion of the straight body portion, the curved portion, and the bottom portion of the silica container to be manufactured, the method further comprises a step of preparing an amorphous silica powder having a particle size of 10 to 1000 µm as a third raw material powder, and the method further comprises, after manufacturing the silica container by performing heating based on the electric discharge heating and melting method, a step of performing melting based on the electric discharge heating and melting method while spreading the third raw material powder from the upper side of the silica container, allowing the molten third raw material powder to adhere to an inner surface portion of the bottom portion, and thereby forming a bottom portion silica glass layer.

According to such a method for manufacturing a silica container, the inner surface layer portion of the straight body portion, the curved portion and the bottom portion can be formed as the mixed silica layer in which the phase in which the crystalline silica powder is fused and the phase in which the amorphous silica powder is fused are mixed in the granular texture, and it is possible to manufacture the silica container for pulling single crystal silicon which has the bottom portion silica glass layer on the inner surface of the mixed silica layer of the bottom portion. The mixed silica layer exposing portion that is not covered with the bottom portion silica glass layer is subjected to the etching (erosion) by the silicon melt when the raw material silicon melt is held in the silica container. As to this etching, the phase in which the amorphous silica powder is fused has a higher rate and a higher etching amount than the phase in which the crystalline silica powder is fused. This difference in etching effect enables forming fine irregularities of the surface of the mixed silica layer (an interface with the raw material silicon melt). Presence of the fine irregularities enables suppressing the melt surface vibration of the silicon melt in the silica container at a high temperature. Furthermore, even if the etching of the mixed silica layer proceeds due to the prolonged use at a high temperature, the fine irregularities continues existing without being annihilated, and hence the melt surface vibration of the silicon melt can be suppressed for a long time.

Moreover, in this silica container, since the mixed silica layer is exposed on the inner surface of the silica container in the straight body portion and the curved portion, the melt surface vibration of the silicon melt can be effectively suppressed in the initial stage (seeding, necking, shouldering, and others) and subsequent stages (pulling and tailing) of the method for pulling single crystal silicon. Additionally, since the bottom portion of the silica container is covered with the bottom portion silica glass layer, irregularities due to the mixed silica layer are not formed in the bottom portion, and hence gaseous bubbles do not grow. Therefore, it is possible to suppress generation of void defects called voids or pin holes in the single crystal silicon due to the gaseous bubbles in the silicon melt.

In this case, it is preferable to form the mixed silica layer with a thickness of 2 mm or more in a wall thickness direction of the silica container.

When the mixed silica layer having such a thickness is formed, the melt surface vibration of the raw material silicon melt can be further assuredly suppressed in the manufactured silica container, and its effect can be sustained.

Further, in the silica container for pulling single crystal silicon according to the present invention, it is preferable to heat the second temporary compact based on an electric discharge heating and melting method while reducing a pressure from the outside of the second temporary compact.

As described above, the heating performed while reducing a pressure enables efficiently producing opaque silica glass of the outer part of the container and transparent silica glass of the inner part of the container.

Furthermore, in the second raw material powder, it is preferable to set OH group concentration of the crystalline silica powder to 50 massppm or less and OH group concentration of the amorphous silica powder to 200 to 2000 ppm.

When the OH group concentrations in both the silica powders constituting the second raw material powder are set in this manner, a difference in etching rate relative to the silicon melt between the phase in which the crystalline silica powder is fused and the phase in which the amorphous silica powder is fused in the mixed silica layer to be fabricated can be made more prominent, and the irregularities of the inner surface of the silica container can be assuredly formed.

Moreover, it is preferable to set concentration of each of impurity elements Li, Na, and K in the second raw material powder to 100 massppb or less, set the concentration of each of impurity elements Ca and Mg in the second raw material powder to 50 massppb or less, and set the concentration of each of impurities Ti, Cr, Fe, Ni, Cu, Zn, Zr, Mo, W, and Pb in the second raw material powder to 20 massppb or less.

When the impurity element concentration in the second raw material powder is set as described above, it is possible to reduce the impurity elements that are taken into the raw material silicon melt when the mixed silica layer to be fabricated is etched.

Additionally, according to the present invention, there is provided a silica container for pulling single crystal silicon, the container having a straight body portion, a curved portion, and a bottom portion, wherein an outer side of the container is made of opaque silica glass containing bubbles, and an inner side of the container is made of transparent silica glass, and wherein a mixed silica layer in which a phase in which a crystalline silica powder is fused and a phase in which an amorphous silica powder is fused are mixed in a granular texture is provided on at least an inner surface layer portion of the straight body portion.

In the above-described silica container having the configuration of the mixed silica layer and others, when the raw material silicon melt is held inside, fine irregularities are formed on the surface of the mixed silica layer by etching due to the silicon melt. Presence of such fine irregularities enables suppressing the melt surface vibration of the silicon melt in the silica container.

In this case, it is preferable to form the mixed silica layer to include a position on an inner surface corresponding to a melt surface in the initial stage when the silica container holds a raw material silicon melt in the inner surface of the silica container.

When the mixed silica layer is formed at such a position, it is possible to effectively suppress the melt surface vibration of the silicon melt in the initial stage of the method for pulling single crystal silicon in particular.

Further, it is preferable to provide the mixed silica layer on the inner surface layer portion of the straight body portion and the curved portion.

When the inner surface layer portion of each of the straight body portion and the curved portion in the silica container has the mixed silica layer, it is possible to effectively suppress the melt surface vibration of the silicon melt in the initial stage (seeding, necking, shouldering, and others) as well as subsequent stages (pulling and tailing) of the single crystal silicon pulling.

Furthermore, it is preferable for the mixed silica layer to have a thickness of 2 mm or more in a wall thickness direction of the silica layer and a width of 100 mm or more.

When the mixed silica layer having the thickness and the width described above is formed, the melt surface vibration of the raw material silicon melt can be more assuredly suppressed and sustained.

Moreover, it is preferable that a high-purity silica glass layer in which concentration of each of impurity elements Li, Na, and K is 50 massppb or less, concentration of each of impurity elements Ca and Mg is 25 massppb or less, and concentration of each of impurity elements Ti, Cr, Fe, Ni, Cu, Zn, Zr, Mo, W, and Pb is 10 massppb or less and which has a thickness of 200 to 2000 µm is provided on at least part of an inner surface where the mixed silica layer is not formed in the inner surface of the silica container.

When such a high-purity silica glass layer is additionally provided, it is possible to further reduce the impurity elements that are taken into the raw material silicon melt from the inner wall of the silica container at the time of use at a high temperature.

Additionally, the silica container for pulling single crystal silicon according to the present invention can have the mixed silica layer on the inner surface layer portion of the straight body portion, the curved portion, and the bottom portion, and have a bottom portion silica glass layer on an inner surface of the mixed silica layer on the bottom portion.

In such a silica container having the configuration of the mixed silica layer, the bottom portion silica glass layer, and others, when the raw material silicon melt is held inside, fine irregularities are formed on the surface of the mixed silica layer by etching due to the silicon melt. Presence of the fine irregularities enables suppressing the melt surface vibration of the silicon melt in the silica container at a high temperature. Further, in each of the straight body portion and the curved portion of this silica container, since the mixed silica layer is exposed on the inner surface of the silica container, it is possible to effectively suppress the melt surface vibration of the silicon melt in the initial stage and subsequent stages of the method for pulling single crystal silicon. Furthermore, since the bottom portion of the silica container is covered with the bottom portion silica glass layer, it is possible to suppress generation of void defects called voids or pin holes in the single crystal silicon due to gaseous bubbles in the silicon melt.

Moreover, in the silica container for pulling single crystal silicon according to the present invention, it is preferable for the mixed silica layer to be formed by using a mixed powder of a crystalline silica powder having OH group concentration of 50 massppm or less and an amorphous silica powder having OH group concentration of 200 to 2000 ppm as a raw material.

When the mixed silica layer is made of the mixed powder of the two types of silica powders having a difference in OH group concentration described above as the raw material, a difference in etching rate relative to the silicon melt between the phase in which the crystalline silica powder is fused and the phase in which the amorphous silica powder is fused in the mixed silica layer can be made more prominent, and the irregularities of the inner surface of the silica container can be more assuredly formed.

Additionally, it is preferable to set concentration of each of impurity elements Li, Na, and K in the mixed silica layer to 100 massppb or less, set the same of each of impurity elements Ca and Mg in the mixed silica layer to 50 massppb or less, and set the same of each of impurities Ti, Cr, Fe, Ni, Cu, Zn, Zr, Mo, W, and Pb in the mixed silica layer to 20 massppb or less.

When the impurity element concentration in the mixed silica layer is set as described above, it is possible to further reduce the impurity elements that are taken into the raw material silicon melt when the mixed silica layer is etched.

### ADVANTAGEOUS EFFECTS OF INVENTION

The method for manufacturing a silica container for pulling single crystal silicon according to the present invention enables manufacturing the silica container for pulling single crystal silicon in which the inner surface layer portion of at least the straight body portion is formed as the mixed silica layer in which the phase in which the crystalline silica powder is fused and the phase in which the amorphous silica powder is fused are mixed in a granular texture.

In the silica container for pulling single crystal silicon according to the present invention having the above-described mixed silica layer, when the raw material silicon melt is held inside, the fine irregularities are formed on the surface of the mixed silica layer due to a difference in etching effect between the phase in which the amorphous silica powder is fused and the phase in which the crystalline silica powder is fused constituting the mixed silica layer. Presence of the fine irregularities enables suppressing the melt surface vibration of the silicon melt in the silica container at a high temperature. Further, even if etching of the mixed silica layer proceeds due to long-time use at a high temperature, since the fine irregularities continue existing without being annihilated, the effect of suppressing the melt surface vibration of the silicon melt can be maintained for a long time. Since the effect of preventing the melt surface vibration continues for a long time, it has a beneficial effect on multiple pulling (multi-pulling) of single crystal silicon in particular, and a life span of the silica container can be extended.

Furthermore, the method for manufacturing a silica container for pulling single crystal silicon according to the present invention enables manufacturing the silica container for pulling single crystal silicon, which has the mixed silica layer having the phase in which the crystalline silica powder is fused and the phase in which the amorphous silica powder is fused mixed therein in the inner surface layer portion of each of the straight body portion, the curved portion, and the bottom portion and also has the bottom portion silica glass layer on the inner surface of the mixed silica layer of the bottom portion.

In such a silica container for pulling single crystal silicon according to the present invention having the mixed silica layer and the bottom portion silica glass layer, since the mixed silica layer is exposed on the inner surface of the silica container in each of the straight body portion and the curved portion, it is possible to effectively suppress the melt surface vibration of the silicon melt in the initial stage and subsequent stages of the method for pulling single crystal silicon. Moreover, since the bottom portion of the silica container is covered with the bottom portion silica glass layer, it is possible to suppress occurrence of void defects called voids or pin holes in the single crystal silicon due to gaseous bubbles in the silicon melt.

### BRIEF DESCRIPTION OF DRAWINGS

FIG. 1 is a schematic cross-sectional view schematically showing an example of a configuration of a silica container according to a first embodiment of the present invention;
FIG. 2 is a schematic cross-sectional view schematically showing another example of the configuration of the silica container according to the first embodiment of the present invention;
FIG. 3 is a schematic cross-sectional view schematically showing still another example of the configuration of the silica container according to the first embodiment of the present invention;
FIG. 4 is a schematic cross-sectional view schematically showing yet another example of the configuration of the silica container according to the first embodiment of the present invention;
FIG. 5 is a schematic cross-sectional view schematically showing a further example of the configuration of the silica container according to the first embodiment of the present invention;
FIG. 6 is a flowchart showing an outline of an example of a method for manufacturing a silica container according to the first embodiment of the present invention;
FIG. 7 is a schematic cross-sectional view showing an example of a mold that can be used in the method for manufacturing a silica container according to the present invention;
FIG. 8 is a schematic cross-sectional view showing another example of the mold that can be used in the method for manufacturing a silica container according to the present invention;
FIG. 9 is a schematic cross-sectional view schematically showing an example of a step of forming a first temporary compact in the method for manufacturing a silica container according to the first embodiment of the present invention;
FIG. 10 is a schematic cross-sectional view schematically showing an example of a step of forming a second temporary compact in the method for manufacturing a silica container according to the first embodiment of the present invention;
FIG. 11 is a schematic cross-sectional view schematically showing a part (before electric discharge heating and melting) of a step of heating the second temporary compact in the method for manufacturing a silica container according to the first embodiment of the present invention;
FIG. 12 is a schematic cross-sectional view schematically showing a part (during the electric discharge heating and melting) of the step of heating the second temporary compact in the method for manufacturing a silica container according to the first embodiment of the present invention;
FIG. 13 is a schematic cross-sectional view schematically showing a part of a step of forming a high-purity silica glass layer on an inner surface portion of a bottom portion as an arbitrary additional step in the method for manufacturing a silica container according to the first embodiment of the present invention;
FIG. 14 is a schematic cross-sectional view schematically showing an example of a configuration of a silica container according to a second embodiment of the present invention;
FIG. 15 is a schematic cross-sectional view schematically showing another example of the configuration of the silica container according to the second embodiment of the present invention;
FIG. 16 is a flowchart showing an outline of an example a method for manufacturing a silica container according to the second embodiment of the present invention;
FIG. 17 is a schematic cross-sectional view schematically showing an example of a step of forming the first temporary compact in the method for manufacturing a silica container according to the second embodiment of the present invention;
FIG. 18 is a schematic cross-sectional view schematically showing an example of a step of forming the second temporary compact in the method for manufacturing a silica container according to the second embodiment of the present invention;
FIG. 19 is a schematic cross-sectional view schematically showing a part (before the electric discharge heating and melting) of an example of a step of heating the second temporary compact in the method for manufacturing a silica container according to the second embodiment of the present invention;
FIG. 20 is a schematic cross-sectional view schematically showing a part (during the electric discharge heating and melting) of the example of a step of heating the second temporary compact in the method for manufacturing a silica container according to the second embodiment of the present invention;
FIG. 21 is a schematic cross-sectional view schematically showing an example of a step of forming a bottom portion silica glass layer in the method for manufacturing a silica container according to the second embodiment of the present invention;
FIG. 22 is a schematic cross-sectional view schematically showing a configuration of a silica container according to Comparative Example 3;
FIG. 23 is a schematic cross-sectional view schematically showing a configuration of a silica container according to Comparative Example 4;
FIG. 24 is a schematic cross-sectional view schematically showing a configuration of a silica container according to Comparative Example 5; and
FIG. 25 is a schematic cross-sectional view schematically showing a configuration of a silica container according to Example 21.

### DESCRIPTION OF EMBODIMENTS

A silica container for pulling single crystal silicon according to the present invention is configured to contain polycrystalline silicon or the like that serves as a raw material of single crystal silicon therein, melt the polycrystalline silicon or the like to provide a raw material silicon melt, and pull single crystal silicon from this melt. The silica container according to the present invention can be used as a silica container for pulling single crystal silicon used for a large-scale integrated circuit (LSI) or photovoltaic power generation (a photovoltaic cell, PV).

Although the silica container for pulling single crystal silicon and a manufacturing method thereof according to the present invention will now be described hereinafter in detail with reference to the drawings, the present invention is not restricted thereto. In particular, an example of a large-diameter silica container for manufacturing single crystal silicon will be explained hereinafter. It is to be noted that the silica container according to the present invention means a silica crucible.

### (First Embodiment)

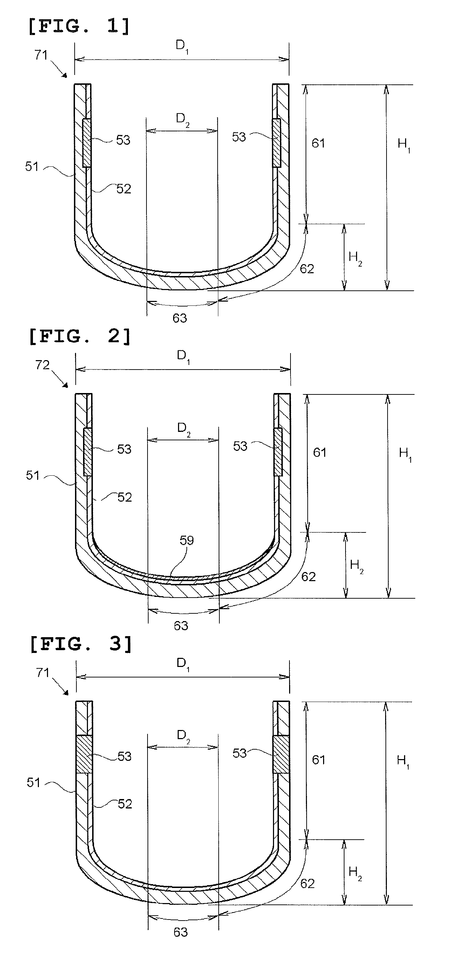

A first embodiment according to the present invention will be first explained. FIG. 1 to FIG. 5 show examples a configuration of a silica container for pulling single crystal silicon according to the first embodiment of the present invention. A description will be first given with reference to FIG. 1. As shown in FIG. 1, a silica container 71 according to the first embodiment of the present invention has a crucible shape having rotation axis symmetry and has a straight body portion 61, a curved portion 62, and a bottom portion 63. At this time, 1/3 of an outer diameter (D₁) of the silica container 71 is determined as a diameter (D₂) of the bottom portion for the convenience's sake. The bottom portion 63 is a circular portion. The straight body portion 61 is a cylindrical portion from an upper edge of the silica container 71 to a height portion that is 1/3 of a height (H₁) (a height H₁-H₂). Moreover, a portion from the height portion that is 1/3 of the height (H₁) of the silica container 71 to the bottom portion 63 (the height H₂) excluding the bottom portion 63 is determined as the curved portion 62.

The silica container 71 has a mixed silica layer 53 on an inner surface layer portion of at least the straight body portion 61. The mixed silica layer 53 is constituted by mixing a phase in which a crystalline silica powder is fused and a phase in which an amorphous silica powder is fused in a granular texture. The mixed silica layer 53 has a non-uniform fine granular texture in units of several hundred µm to several thousand µm. More specifically, the phase in which the crystalline silica powder is fused constituting the mixed silica layer 53 uses the crystalline silica powder such as quartz powder, rock crystal powder, cristobalite powder, or the like as a raw material, and the phase in which the amorphous silica powder is fused constituting the mixed silica layer 53 uses the amorphous silica powder such as synthetic silica glass powder obtained by a flame hydrolysis method, fused silica glass powder, or the like obtained by an oxyhydrogen Bernoulli method, or the like as a raw material. That is, the mixed silica layer 53 is a silica layer provided by melting and integrating these types of mixed powder.

Additionally, in the silica container 71, a container outer side is made of opaque silica glass containing bubbles, and a container inner side is made of transparent silica glass. In the silica container 71, when such a two-layer structure is adopted, thermal uniformity in the silica container 71 can be assured at the time of using the silica container at a high temperature. This opaque silica glass is usually white opaque. The transparent silica glass is transparent since it does not substantially contain bubbles, and it is usually colorless and transparent. Bulk density of the opaque silica glass 51 is approximately 1.90 to 2.15 (g/cm³), and bulk density of the transparent silica glass 52 is approximately 2.20 (g/cm³). To show a position of the mixed silica layer 53, the opaque silica glass 51 and the transparent silica glass 52 are shown in portions excluding the mixed silica layer 53 in the drawing. In reality, a portion of the mixed silica layer 53 that is placed in a container outer region is also made of the opaque silica glass, and a portion of the same that is placed in a container inner region is made of the transparent silica glass.

When the silicon melt is held in the silica container 71 as a raw material for pulling single crystal silicon, an inner surface of the silica container 71 undergoes etching (erosion) by the silicon melt due to a reaction (a melting reaction) between a silica component constituting the inner surface of the silica container 71 and the silicon melt. At this time, in the mixed silica layer 53, the phase in which the crystalline silica powder is fused has a smaller etching amount (an erosion amount) (i.e., a lower etching rate) than the phase in which the amorphous silica powder is fused, a portion having a granular structure in the phase in which the crystalline silica powder is fused becomes a convex portion, and the phase in which the amorphous silica powder is fused becomes a concave portion. This difference in etching effect enables forming fine irregularities of a surface of the mixed silica layer 53 (an interface with respect to the raw material silicon melt), and the surface turns to a scabrous rough surface. Due to generation of this rough surface, fine vibration is hard to occur on a melt surface of the molten silicon in the silica container at a high temperature, and the melt surface vibration that occurs like waves can be suppressed by the rough surface even if the fine vibration occurs. This is similar to a phenomenon that waves on the sea surface are stopped by arranging wave dissipating blocks as tetrapods on a shore. As described above, the mixed silica layer 53 functions as a melt surface vibration suppression layer.

Further, even if the etching of the mixed silica layer 53 proceeds due to long-time use at a high temperature, since the mixed silica layer 53 has a certain thickness in the silica container 71 according to the first embodiment of the present invention, the fine irregularities (the rough surface) continue existing without being annihilated, and the melt surface vibration of the silicon melt can be suppressed for a long time. Since the effect of preventing the melt surface vibration continues for a long time, it particularly has a beneficial effect on multiple pulling (multi-pulling) of single crystal silicon.

Although the mixed silica layer 53 is typically formed as a belt-like inner peripheral layer on the inner surface layer portion of the silica container 71 having the crucible shape as shown in FIG. 1, the present invention is not restricted thereto. Furthermore, it is preferable for the mixed silica layer 53 to be formed while including a position on the inner surface corresponding to a melt surface in the initial stage (an initial melt surface) when the silica container 71 holds the raw material silicon melt. When a position at which the mixed silica layer 53 is formed is set in this manner, it is possible to effectively suppress the melt surface vibration of the raw material silicon melt in the initial stage (seeding, necking, shouldering, and others) of the method for pulling single crystal silicon in particular. In the pulling of single crystal silicon, it is considerably important to suppress the melt surface vibration at steps in the initial stage. If the melt surface vibration can be suppressed at initial steps, pulling can be stably performed at a subsequent single crystal silicon pulling step. In case of the silica container 71 according to the first embodiment of the present invention, the melt surface vibration can be suppressed even in a large-diameter silica container having a diameter of 30 inches (75 cm) to a diameter of 54 inches (135 cm) for pulling large-diameter single crystal silicon having a diameter of 12 inches (30 cm) to a diameter of 18 inches (45 cm) in particular.

It is preferable for the mixed silica layer 53 to have a thickness of 2 mm or more in a wall thickness direction of the silica container 71 and a width of 100 mm or more. The "width" of the mixed silica layer 53 used herein means a length of a region of the mixed silica layer 53 exposed on the inner surface of the silica container 71, in the height direction of the silica container 71. Although the mixed silica layer 53 is gradually etched and thinned during use of the silica container at a high temperature in a state that the raw material silicon melt is held, the melt surface vibration of the raw material silicon melt can be more assuredly suppressed for a long time by setting the thickness of the mixed silica layer 53 to 2 mm or more. Additionally, when the width (the height) of the mixed silica layer 53 is set to 100 mm or more, the mixed silica layer 53 can be allowed to make correspondent to the melt surface level more assuredly in the initial stage of pulling single crystal silicon. Further, even if the melt surface level of the raw material silicon melt is lowered during the pulling of single crystal silicon, the effect of suppressing the melt surface vibration can be sustained for a certain period of time.

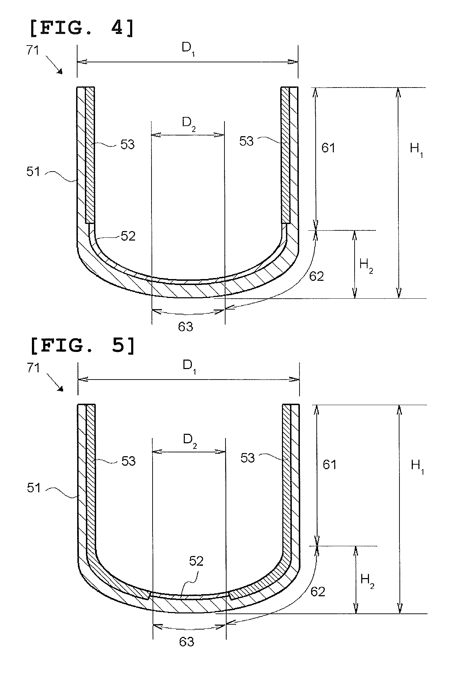

Forming the mixed silica layer 53 in at least part of the inner surface layer portion of the straight body portion can suffice, and the mixed silica layer 53 may include any other region. For example, as shown in FIG. 3, the mixed silica layer 53 may be formed to pierce through a sidewall of the straight body portion 61 of the silica container 71. Furthermore, as shown in FIG. 4, the mixed silica layer 53 may be formed to reach an upper edge of the silica container 71. In this case, a portion above a certain height in the sidewall of the straight body portion 61 may be all formed as the mixed silica layer 53.

Moreover, as shown in FIG. 5, the mixed silica layer 53 may be provided in the inner surface layer portion of each of the straight body portion 61 and the curved portion 62 in the silica container. This configuration enables effectively suppressing the melt surface vibration of the silicon melt in the initial stage (seeding, necking, shouldering, and others) and subsequent stages (pulling and tailing) of the pulling of single crystal silicon.

However, for the following reason, it is preferable not to set the mixed silica layer 53 on the bottom portion 63 of the silica container 71. If the surface of the mixed silica layer 53 is present on the bottom portion 63 of the silica container 71, irregularities are produced on the inner surface of the bottom portion 63 and the inner surface turns a scabrous rough surface at the time of manufacturing single crystal. When the silica glass reacts with the silica glass in this state, a silicon oxide (SiO) gas is generated, gaseous bubbles grow on the irregular surface of the bottom portion 63, the gaseous bubbles move up into the silicon melt to be taken into the single crystal silicon that is in the growth process, and void defects called voids or pin holes are apt to be produced.

Because the diameter of the bottom portion 63 of the silica container 71 is close to a diameter of the single crystal silicon to be manufactured, it is preferable not to set the mixed silica layer 53 on the inner surface of at least the bottom portion 63 of the silica container 71 and to form a layer that is obtained by fusing a raw material powder consisting of the crystalline silica powder alone and made of transparent silica glass without containing bubbles (transparent silica glass 52).

It is preferable for the mixed silica layer 53 to be made by using, as a raw material, a mixed powder of the crystalline silica powder having OH group concentration of 50 massppm or less and the amorphous silica powder having OH group concentration of 200 to 2000 ppm. When the mixed silica layer 53 is formed by using the mixed powder of the two types of silica powder having such a difference in OH group concentration as the raw material, a difference in etching rate relative to the silicon melt between the phase in which the crystalline silica powder is fused and the phase in which the amorphous silica powder is fused in the mixed silica layer 53 can be made more prominent, and the irregularities of the inner surface of the silica container 71 can be more assuredly formed. Although the OH group concentration of the phase in which the crystalline silica powder is fused corresponds to the OH group concentration of the crystalline silica powder and the OH group concentration of the phase in which the amorphous silica powder is fused corresponds to the OH group concentration of the amorphous silica powder, respectively, the silica container 71 is manufactured through a high-temperature step of approximately 1800°C, and hence some fluctuations are considered to occur. It is to be noted that, when the OH group concentration of the entire mixed silica layer 53 is measured by infrared spectroscopy photometry, a value is approximately an average of the OH group concentration of both the types of raw material powder.

The mixed silica layer 53 is etched from its interface when the raw material silicon melt is held. It is preferable to reduce an amount of impurity elements taken into the raw material silicon melt from the mixed silica layer 53 by increasing purity of the mixed silica layer 53. Specifically, it is preferable for concentration of each of impurity elements Li, Na, and K in the mixed silica layer 53 to be 100 massppb or less, the same of each of Ca and Mg in the mixed silica layer 53 to be 50 massppb or less, and the same of each of Ti, Cr, Fe, Ni, Cu, Zn, Zr, Mo, W, and Pb in the mixed silica layer 53 to be 20 massppb or less.

FIG. 2 shows an outline of another example of the silica container according to the first embodiment of the present invention. Like reference numerals denote elements corresponding to the silica container shown in FIG. 1, and an overlapping description will be omitted. The silica container 72 shown in FIG. 2 has a high-purity silica glass layer 59 on at least part of the inner surface where the mixed silica layer 53 is not formed therein. As shown in FIG. 2, it is preferable to form the high-purity silica glass layer 59 on the inner surface of the bottom portion 63. However, the present invention is not restricted thereto, and the high-purity silica glass layer 59 may be formed to cut across the curved portion 62 and the bottom portion 63, or it may be formed on all portions on the inner surface of the silica container 72 excluding the mixed silica layer 53. Moreover, if there is a portion where the mixed silica layer 53 is exposed on the inner surface of the silica container 72, part of the mixed silica layer 53 may be covered with the high-purity silica glass layer 59.

In the high-purity silica glass layer 59, specifically, it is preferable for concentration of each of impurity elements Li, Na, and K to be 50 massppb or less, and the same of each of Ca and Mg to be 25 massppb or less, the same of each of Ti, Cr, Fe, Ni, Cu, Zn, Zr, Mo, W, and Pb to be 10 massppb or less, and a thickness of this layer to be 200 to 2000 µm. When the silica container 72 additionally has the high-purity silica glass layer 59, it is possible to further reduce impurity elements taken into the raw material silicon melt from the inner wall of the silica container 72 at the time of use at a high temperature. This conformation is particularly preferable for use applications requiring high purity.

Although depending on use applications, it is preferable to set purity of any other portion (which may be also referred to as a "usual silica portion" hereinafter) than the mixed silica layer 53 (and the high-purity silica glass layer 59) in each of the silica containers 71 and 72 shown in FIG. 1 to FIG. 5 to 99.99 mass% or more for pulling a solar single crystal and 99.999 mass% or more for pulling an LSI single crystal as silica (SiO₂) purity. Further, in case of using silica raw material powder containing approximately 10 massppm of each of, e.g., alkali metal elements Li, Na, and K as the raw material powder for fabricating this usual silica portion, for example, when the OH group concentration in the usual silica portion is set to 10 to 50 massppm and Al is also set to 5 to 30 massppm, elements having high diffusion coefficient values like these alkali metal elements can be adsorbed or confined to a thick wall of the silica container. As an effect of containing an OH group, there is a good effect of adsorbing and fixing metal impurity elements, but there is also a negative effect that viscosity at a high temperature is lowered and the silica container is deformed, and hence setting values to fall within the above-described ranges is preferable. Although Al has an effect that metal impurity elements are adsorbed and fixed and a good effect that the viscosity of silica glass at a high temperature is improved, but it also has a negative effect that the silicon melt of a processing target is contaminated with Al. Therefore, even in case of containing Al, using the range of 5 to 30 massppm (or more preferably, 10 to 20 massppm) as described above is desirable.

In the following description, a method for manufacturing a silica container for pulling a single crystal silicon according to the first embodiment of the present invention, which can manufacture each of the silica containers 71 and 72 can be manufactured, will now be specifically described.

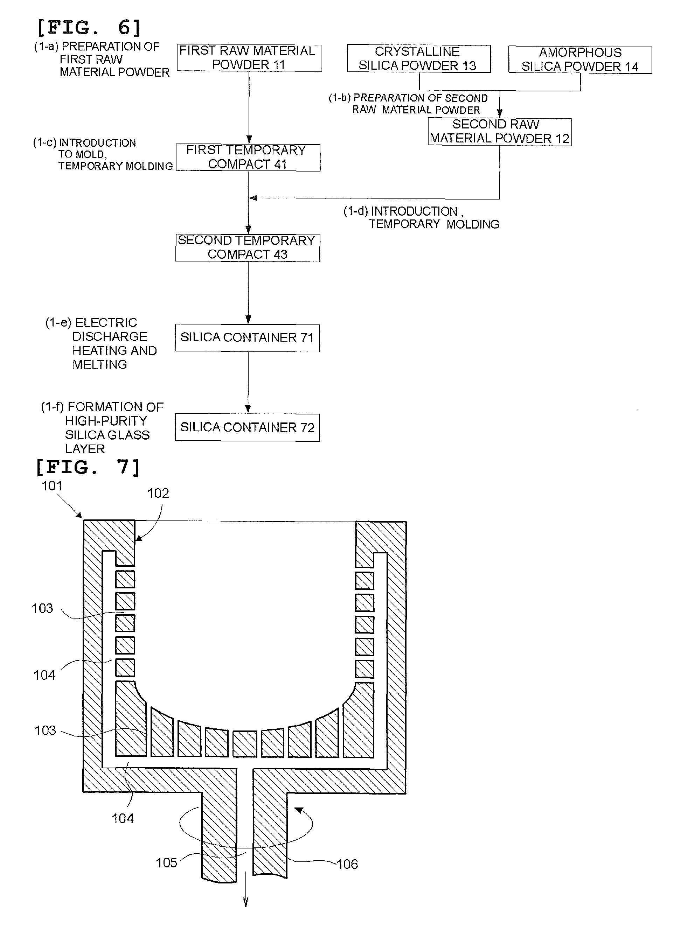

The method for manufacturing the silica container 71 shown in FIG. 1 will be first explained with reference to FIG. 6.

As shown in (1-a) and (1-b) in FIG. 6, a first raw material powder 11 and a second raw material powder 2 are prepared (a step (1-a), a step (1-b). The first raw material powder 11 can be prepared before a later-described step of fabricating a first temporary compact 41, and the second raw material powder 12 can be prepared before a later-described step of fabricating a second temporary compact.

### (Preparation of First Raw material Powder 11)

The first raw material powder 11 serves as a material constituting a portion (the usual silica portion) other than the mixed silica layer 53 (and the high-purity silica glass layer 59) in each of the silica containers 71 and 72. As the first raw material powder 11, a crystalline silica powder having a particle size of 10 to 1000 µm is prepared (the step (1-a)). The first raw material powder 11 can be prepared by, e.g., pulverizing and grading a silica rock as described below, but the present invention is not restricted thereto.

First, a natural silica rock (rock crystal, quartz, silica, a siliceous rock, an opal stone, or the like that are naturally produced) having a diameter of approximately 5 to 50 mm is heated in an air atmosphere in the temperature range of 600 to 1000°C for approximately 1 to 10 hours. Then, the natural silica stone is put into water, rapidly cooled, then taken out, and dried. This processing facilitates processing such as pulverization using a crusher or grading, but the pulverization processing may be performed without effecting this heating and rapid cooling processing.

Then, the natural silica stone is pulverized by a crusher or the like and graded, and a particle size is adjusted to 10 to 1000 µm or preferably 50 to 500 µm, thereby obtaining a natural silica powder.

Then, this natural silica powder is put into a rotary kiln formed of a silica glass tube having an inclination angle, a hydrochloric (HCl) or chlorine (Cl₂) gas containing atmosphere is formed in the kiln, and heating is performed at 800 to 1100°C for approximately 1 to 100 hours, thereby performing purity raising processing. However, in a use application of a product that does not require high purity, subsequent processing may be performed without effecting this purity raising processing.

The first raw material powder 11 obtained after the above-described step is crystalline silica.

A particle size of the first raw material powder 11 is determined as 10 to 1000 µm as described above. It is preferable to set this particle size to 50 to 500 µm. It is preferable to set silica purity (SiO₂) of the first raw material powder 11 to 99.99 mass% or more desirably 99.999 mass%.

When the purity of the first raw material powder 11 is low (poor), to prevent impurity metal elements from moving and diffusing from the manufactured silica container 71 or 72 into the inner surface and into the contained silicon melt, certain amounts of Al and an OH group can be contained in the first raw material powder 11. Al can be obtained by using nitrate, acetate, carbonate, a chloride, or the like as an aqueous or alcohol solution, putting and immersing the silica powder in such a solution, and then performing drying. As to the OH group, moisture contained in the natural silica from the beginning or mixed at an intermediate step can be adjusted based on a gas atmosphere, a processing temperature, and a time in a subsequent drying step. It is preferable to set the content of Al in the first raw material powder 11 for constituting the usual silica portion to 5 to 30 massppm as described above. Although the OH group concentration of the first raw material powder 11 can be set to 10 to 50 massppm, but the OH group concentration can be adjusted at subsequent steps as described above.

Although particulars of a mechanism that inclusion of the OH group prevents movement and diffusion of the impurity metal elements in the silica glass are unknown, it can be considered that positive ions (cations) of the impurity metal elements are adsorbed and diffusion of them is prevented in terms of keeping electric charge balance in a silica glass network by substitution with Si. Additionally, as to the OH group, when hydrogen ions are substituted with metal ions, an effect of adsorption of the impurity metal elements or preventing diffusion of them is produced.

### (Preparation of Second Raw material Powder)

The second raw material powder 12 serves as a material constituting the mixed silica layer 53. As the second raw material powder 12, a mixed powder of a crystalline silica powder 13 having a particle size of 50 to 2000 µm and an amorphous silica powder 14 having a particle size of 50 to 2000 µm is prepared (the step (1-b)). The second raw material powder 12 can be prepared by individually preparing the crystalline silica powder 13 and the amorphous silica powder 14 and mixing them.

### (Preparation of Crystalline Silica Powder 13)

Although the crystalline silica powder 13 can be basically prepared in the same manner as preparation of the first raw material powder 11, a particle size is set to 50 to 2000 µm. When the particle size that is relatively rough as described above is adopted, a phase in which the crystalline silica powder is fused in the mixed silica layer 53 is hard to be etched by the silicon melt, which is preferable. Further, it is desirable to set OH group concentration of the crystalline silica powder 13 to 50 massppm or less as described later. Although the phase in which the crystalline silica powder is fused itself is hardly etched with respect to the silicon melt, the crystalline silica powder 13 serves as a raw material constituting the mixed silica layer 53 that is intended to be etched, and hence it is better to prevent the Al element from being contained in the crystalline silica powder 13 while considering contamination of the silicon melt due to Al itself. However, Al may be contained in a crystalline silica powder 13 depending on situations.

### (Preparation of Amorphous Silica Powder 14)

Examples of material of the amorphous silica powder 14 include the following: a material obtained by subjecting a natural quartz powder, a natural rock crystal powder, or a cristobalite powder to a purity raising processing, melting it using oxyhydrogen flames to provide a silica glass block and then performing pulverization and grading; and a silica glass powder obtained by pulverizing and grading a synthetic silica glass block provided by an oxyhydrogen flame hydrolysis method using a silicon compound such as silicon tetrachloride (SiCl₄). A particle size of the second raw material powder 12 is set to 50 to 2000 µm or preferably 300 to 1000 µm. It is preferable to set purity to 99.999 mass% or more of a silica component (SiO₂), or more specifically, set concentration of each of impurity elements Li, Na, and K to 100 massppb or less, concentration of each of Ca and Mg to 50 massppb or less, and each of Ti, Cr, Fe, Ni, Cu, Zn, Zr, Mo, W, and Pb to 20 massppb or less.

### (Preparing by Mixing of Second Raw material Powder 12)

The second raw material powder 12 can be prepared by mixing the crystalline silica powder 13 and the amorphous silica powder 14 prepared as described above. To provide an appropriate configuration of the rough surface when the mixed silica layer 53 is etched with the silicon melt, it is preferable to set a mixing ratio of the two types of silica powder to 90 to 20 mass% or more desirably to 80 to 50 mass% for the crystalline silica powder 13. A remaining percentage corresponds to the amorphous silica powder 14.

In the second raw material powder 12, it is preferable to set the OH group concentration of the crystalline silica powder 13 to 50 massppm or less and set the OH group concentration of the amorphous silica powder 14 to 200 to 2000 ppm. The OH group concentration of the crystalline silica powder 13 can be adjusted as described above. It is preferable to set a vapor release amount of the crystalline silica powder 13 to 2×10¹⁷ (H₂O molecules/g) or less. Various well-known methods can be used for adjustment of the OH group concentration of the amorphous silica powder 14. For example, in case of melting the natural quartz powder, the natural rock crystal powder, or the cristobalite powder subjected to the purity raising processing, by using oxyhydrogen flames, adjusting flow rates of oxygen and hydrogen in the oxyhydrogen flames enables adjusting the OH group concentration in the amorphous silica powder 14. Moreover, in case of preparation based on the oxyhydrogen flame hydrolysis method of a silicon compound of silicon tetrachloride, the OH group concentration in the amorphous silica powder 14 can be raised by increasing the flow rates of oxygen and hydrogen compared with the flow rate of the silicon tetrachloride, which is a raw material.

### (Formation of First Temporary Compact)

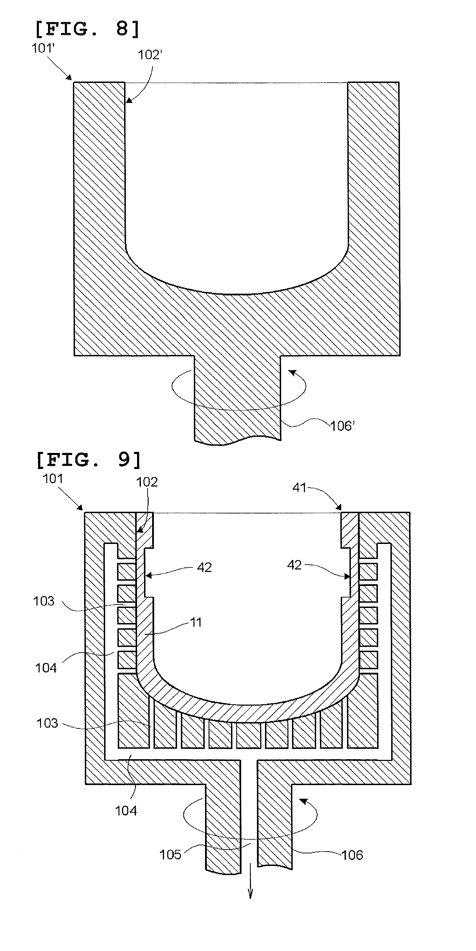

After preparing at least the first raw material powder 11, as shown in (1-c) in FIG. 6, the first raw material powder 11 is put into a mold having rotational symmetry, the powder is temporarily molded into a predetermined shape corresponding to an inner wall of the mold while rotating the mold, and a first temporary compact 41 made of the first raw material powder 11 is formed in the mold (a step (1-c)). Each of FIG. 7 and FIG. 8 is a cross-sectional view showing outline of the mold used for temporarily molding the first raw material powder 11. The mold 101 or 101' used in the first embodiment according to the present invention is made of, e.g., heat resisting ceramic such as graphite or alumina or a heat resisting metal having a cooling system, has the rotation symmetry, and can be rotated by a mold rotation motor (not shown). Furthermore, as shown in FIG. 7, pressure reducing holes 103 may be distributed and formed in an inner wall 102 of the mold 101. The pressure reducing holes 103 are continuous with a pressure reducing passage 104. Moreover, a pressure reducing passage 105 also runs through a rotary shaft 106 configured to rotate the mold 101, and vacuum drawing can be performed through this passage 105. In the first embodiment according to the present invention, such a mold 101' having no pressure reducing equipment as shown in FIG. 8 can also be used. Pressure reducing holes are not formed in an inner wall 102' of this mold 101', and a pressure reducing passage is not formed in a rotary shaft 106'. Although a description will be given as to an example using the mold 101 shown in FIG. 7, the mold 101' shown in FIG. 8 can be likewise used except that pressure reduction is not performed.

At the step (1-c), the first raw material powder 11 is introduced to the inner wall 102 of the mold 101 depicted in FIG. 7, and the first raw material powder 11 is temporarily molded into a predetermined shape corresponding to the inner wall 102 of the mold 101 to provide the first temporary compact 41 (see FIG. 9). Specifically, the first raw material powder 11 is gradually put onto the inner wall 102 of the mold 101 while rotating the mold 101, and it is molded into a container shape having a predetermined thickness by using centrifugal force. Additionally, a wall thickness of the first temporary compact 41 may be adjusted to a predetermined amount by bringing a tabular inner mold (not shown) into contact with the rotating powder body from the inner side. At this time, a region used for introducing the second raw material powder 12 at a subsequent step is left. FIG. 9 shows an example of forming a recess 42 in the first temporary compact 41. Further, although a method for supplying the first raw material powder 11 into the mold 101 is not restricted in particular, for example, a hopper including an agitation screw and a measurement feeder can be used. In this case, the first raw material powder 11 filling the hopper is agitated with the use of the agitation screw and supplied while adjusting a supply amount by the measurement feeder.

Then, as shown in (1-d) in FIG. 6, the second raw material powder 12 is put into the recess 42 of the first temporary compact 41 formed in the mold 101 (a step (1-d)). As a result, a second temporary compact 43 having a portion made of the first raw material powder 11 and a portion made of the second raw material powder 12 are formed. A shape of the second temporary compact 43 is a shape corresponding to a shape of the silica container 71 or 72 to be manufactured, and a portion corresponding to at least part of the inner surface layer portion of the straight body portion of the silica container 71 or 72 to be manufactured is made of the second raw material powder 12. Although the second raw material powder 12 is put after the first temporary compact 41 is formed by using at least part of the first raw material powder 11, the entire second temporary compact 43 can be formed by putting part of the first raw material powder 11 even after putting the second raw material powder 12 as required.

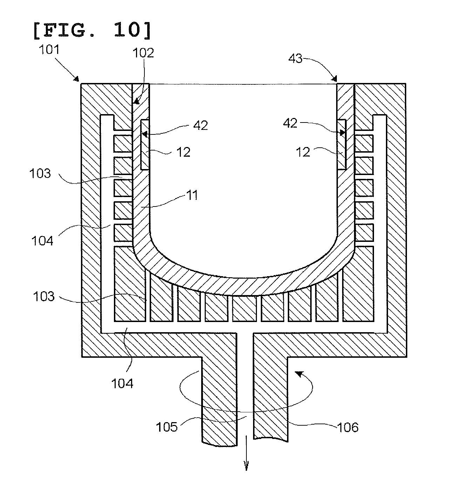

An example shown in FIG. 10 corresponds to the shape of the silica container 71 shown in FIG. 1 or the silica container 72 shown in FIG. 2. In this case, the second raw material powder 12 is put to the inside (the recess 42) of the first temporary compact 41. In case of manufacturing the silica container 71 shown in FIG. 3 to FIG. 5, the shape of the second temporary compact 43 is adjusted to turn to the shape corresponding to each silica container 71. In case of manufacturing the silica container 71 shown in FIG. 3, the first raw material powder 11 is introduced into the mold, then the second raw material powder 12 is introduced to the upper portion of the sidewall of the mold, and the first raw material powder 11 is further introduced to the upper portion of the sidewall. In case of manufacturing the silica container 71 shown in FIG. 4, the recess is formed on the inner side and the upper portion of the first temporary compact 41 to correspond to the shape of the mixed silica layer 53 in FIG. 4, and the second raw material powder 12 is introduced into the recess.

It is preferable for a region occupied by the second raw material powder 12 in the second temporary compact 43 (i.e., a region serving as the mixed silica layer 53) to include a position on the inner surface corresponding to an initial melt surface when the silica container 71 holds the raw material silicon melt. As a result, the silica container 71 enables effectively suppressing the melt surface vibration of the silicon melt in the initial stage of the method for pulling single crystal silicon. In addition, as described above, to further assuredly suppress the melt surface vibration of the raw material silicon melt in the manufactured silica container 71 and sustain its effect, it is preferable to form the mixed silica layer 53 while determining its thickness in the wall thickness direction of the silica container 71 to be 2 mm or more and its width to be 100 mm or more. This can be achieved by adjusting the region occupied by the second raw material powder 12 in the second temporary compact 43.

Further, it is preferable to form the second temporary compact 43 while determining that the second temporary compact 43 has a portion made of the second raw material powder 12 at a position corresponding to the inner surface layer portion of each of the straight body portion 61 and the curved portion 62 of the silica container 71 to be manufactured. When the second temporary compact 43 is formed in this manner, the mixed silica layer 53 can be formed on the inner surface layer portion of the straight body portion 61 and the curved portion 62 of the silica container 71. As a result, it is possible to effectively suppress the melt surface vibration of the silicon melt in the initial stage and subsequent stages of pulling of single crystal silicon.

Then, as shown in (1-e) in FIG. 6, when heating is effected from the inside of the second temporary compact 43 by the electric discharge heating and melting method while rotating the mold 101, the portion made of the second raw material powder 12 in the second temporary compact 43 is formed into the mixed silica layer 53 in which the phase in which the crystalline silica powder is fused and the phase in which the amorphous silica powder is fused are mixed in a granular texture, the container outer side is made of the opaque silica glass 51 containing bubbles, and the container inner side is made of the transparent silica glass 52 (the step (1-e)). It is preferable to heat the second temporary compact 43 based on the electric discharge heating and melting method while reducing a pressure from the outer side of the second temporary compact 43. Heating performed while reducing a pressure enables efficiently producing the opaque silica glass on the container outer side and the transparent silica glass on the container inner side.

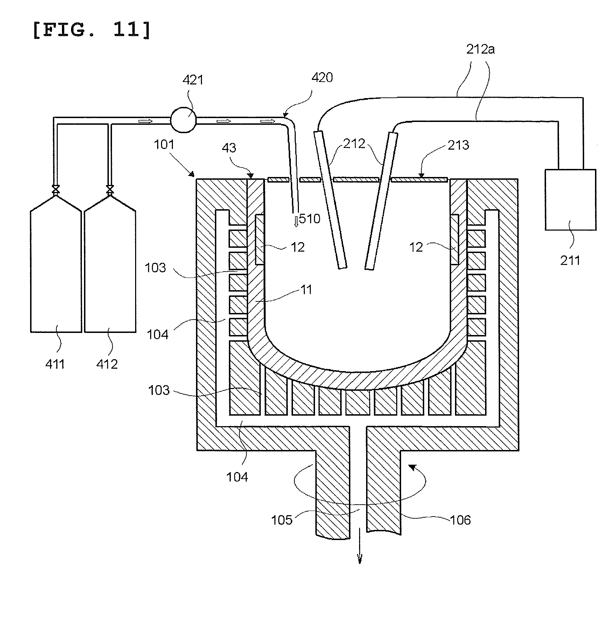

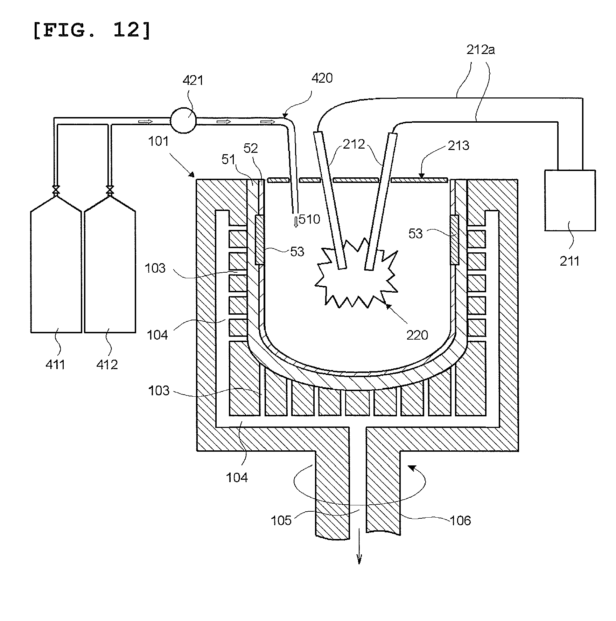

FIG. 11 and FIG. 12 specifically show a state of this step. An apparatus configured to produce this silica container 71 is constituted of the rotatable mold 101 having the rotation axis symmetry, a rotary motor (not shown), carbon electrodes 212 serving as a heat source of electric discharge heating and melting (which is also called arc melting or arc discharge melting), electric wires 212a, a high-voltage power supply unit 211, a lid 213, and others. The number of carbon electrodes 212 is generally two or three. As the power supply, an alternating current or a direct current can be used. Furthermore, the apparatus also includes constituent elements for adjusting an atmospheric gas supplied from the inside of the second temporary compact 43, e.g., a hydrogen gas supply cylinder 411, an inert gas supply cylinder 412, a mixed gas supply tube 420, a gas mixer, a flow rate adjuster 421, and others.

As a melting and sintering procedure of the second temporary compact 43, before starting voltage application between the carbon electrodes 212, it is preferable to start supplying a hydrogen containing gas from the inner side of the second temporary compact 43. Specifically, as shown in FIG. 11, a hydrogen gas is supplied from the hydrogen gas supply cylinder 411, an inert gas (e.g., nitrogen (N₂), argon (Ar), or helium (He)) is supplied from the inert gas supply cylinder 412, these gases are mixed, and the mixed gas is supplied from the inner side of the second temporary compact 43 through the mixed gas supply tube 420. It is to be noted that a void arrow indicated by reference numeral 520 shows a flow of the mixed gas.

Then, in a state that supply of the mixed gas is continued as described above, a degassing vacuum pump (not shown) is activated while rotating the mold 101 having the second temporary compact 43 therein at a certain velocity, a pressure is reduced from the outer side of the second temporary compact 43 through the pressure reducing holes 103 and the pressure reducing passages 104 and 105, and voltage application between the carbon electrodes 212 is started.

When the arc discharge (denoted by reference numeral 220 in FIG. 12) is started between the carbon electrodes 212, an inner surface portion of the second temporary compact 43 reaches a melting temperature range (which is assumed to be approximately 1800 to 2000°C) of the silica powder, and melting starts from the most surface layer portion. When the most surface layer portion is molten, a pressure reduction degree of vacuum drawing using the degassing vacuum pump increases (a pressure is precipitously reduced), and a change into a molten silica glass layer proceeds from the inner side toward the outer side while degassing a dissolved gas of water, oxygen, or the like contained in the first raw material powder 11 and the second raw material powder 12.

Heating based on voltage application is continued until approximately inner one-third to one-half of the total thickness of the second temporary compact 43 is molten to turn to the transparent silica glass and approximately two-thirds to one-half that is the remainder of the outer part turns to sintered opaque silica.

For the purpose of reducing wear of the electrodes, the atmospheric gas in the thick wall portion of the container at the time of this electric discharge heating and melting may contain an inert gas such as nitrogen (N₂), argon (Ar), or helium (He) as a main component, but using hydrogen containing gas as the atmospheric gas is preferable in this step in order to reduce the dissolved gas in the silica glass after melting as described above. This hydrogen containing gas can be a mixed gas consisting of, e.g., a hydrogen gas and an inert gas such as a nitrogen gas (N₂), argon (Ar), or helium (He). Setting a content ratio of the hydrogen gas (H₂) to 1 vol% or more is preferable, and setting the same to 1 to 10 vol% is more preferable. As a reason for this setting, it can be considered that, for example, an oxygen gas (O₂) that is hard to degas reacts with hydrogen to generate water (H₂O), water molecules have a higher diffusion coefficient than oxygen molecules, and hence they are apt to be released to the outside of the outer layer. Moreover, since the hydrogen gas (H₂) has a small molecular radius and a high diffusion coefficient, it is readily released to the outside of the outer layer even though it is contained in the atmospheric gas.

Through the above-described steps, there is manufactured the silica container 71 according to the first embodiment of the present invention in which the mixed silica layer 53 is provided, the container outer side is made of the opaque silica glass containing bubbles, and the container inner side is made of the transparent silica glass (see FIG. 12).

After manufacturing the silica container 71 in this manner, to manufacture the silica container 72 shown in FIG. 2, as an additional step, the high-purity silica glass layer 59 can be formed on at least part of the inner surface where the mixed silica layer 53 is not formed in the inner surface of the silica container 71 (a step (1-f) in FIG. 6). It is preferable to form the high-purity silica glass layer 59 while determining that concentration of each of impurity elements Li, Na, and K is 50 massppb or less, concentration of each of Ca and Mg is 25 massppb or less, concentration of each of Ti, Cr, Fe, Ni, Cu, Zn, Zr, Mo, W, and Pb is 10 massppb or less, and a thickness is 200 to 2000 µm.

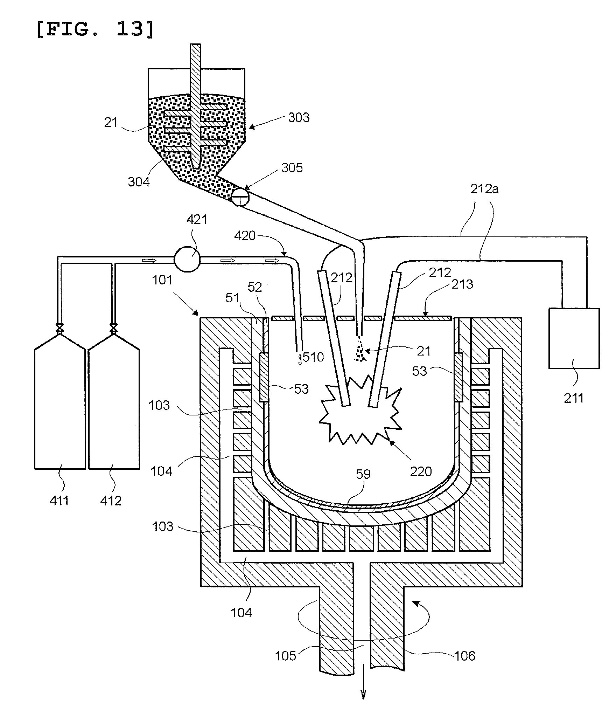

A description will be given as to an example where the high-purity silica glass layer 59 is formed on the container bottom portion like the silica container 72 shown in FIG. 2. At this step, as shown in (1-f) of FIG. 6 and FIG. 13, the high-purity silica glass layer forming raw material powder 21 is molten by the electric discharge heating and melting method while diffusing the high-purity silica glass layer forming raw material powder 21 in an inner space of the silica container 71 produced through the steps (1-a) to (1-e), and the molten high-purity silica glass layer forming raw material 21 is allowed to adhere to the inner surface portion of the bottom portion of the silica container 71, thereby forming the high-purity silica glass layer 59 on the inner surface portion of the bottom portion of the silica container 71. As a result, the silica container 72 shown in FIG. 2 can be manufactured. Although the basic method for forming the high-purity silica glass layer 59 based on this step is similar to contents described in, e.g., Patent Literature 1 and Patent Literature 2, the high-purity silica glass layer 59 is formed on at least part (the container bottom portion surface in case of each of FIG. 2 and FIG. 13) on the inner surface where the mixed silica layer 53 is not formed in the inner surface of the silica container 1 in the first embodiment according to the present invention.

As substantially similar to the step (1-e), the apparatus shown in FIG. 13 that forms the high-purity silica glass layer 59 on the inner surface portion of the bottom portion of the silica container 71 is constituted of the rotatable mold 101 in which the silica container having rotation axis symmetry is installed, the rotary motor (not shown), a hopper 303 for raw material powder having the high-purity silica glass layer forming raw material powder 21 therein, an agitation screw 304, a measurement feeder 305, the carbon electrodes 212 serving as a heat source of the electric discharge heating and melting, electric wires 212a, a high-voltage power supply unit 211, a lid 213, and others. Furthermore, in case of adjusting an atmospheric gas, like the step (1-e), the apparatus may further include the hydrogen gas supply cylinder 411, the inert gas supply cylinder 412, a mixed gas supply tube 420, a gas mixer, a flow rate adjuster 421, and others. Such an apparatus can be continuously used from the step (1-e).

As a method for forming the high-purity silica glass layer 59, first, the mold 101 is set to a predetermined rotation velocity, a high voltage is gradually applied from the high-voltage power supply unit 211 and, at the same time, the high-purity silica glass layer forming raw material powder 21 from the raw material hopper 303 is gradually spread from the upper side of the silica container 71. At this time, electric discharge is started between the carbon electrodes 212, the melting temperature range (which is assumed to be approximately 1800 to 2000°C) of the silica powder is formed in the silica container 71, and hence the spread high-purity silica glass layer forming raw material powder 21 turns to molten particles of silica and adheres to the inner surface of the silica container 71. The carbon electrodes 212, a raw material powder input opening, and the lid 213 disposed at an upper opening portion of the silica container 71 function as a mechanism that changes positions relative to the silica container 71 to some extent, and changing the positions enables forming the high-purity silica glass layer 59 with a predetermined thickness at a predetermined position on the bottom portion of the silica container 71.

For the purpose of reducing wear of the electrodes, the atmospheric gas in the container 71 during the arc discharge melting may contain an inert gas such as nitrogen (N₂), argon (Ar), or helium (He) as a main component, but using a mixed atmosphere containing 1 to 10 vol% of a hydrogen gas enables obtaining the high-purity silica glass layer 59 containing less bubbles.

When carbon fine particles and carbon monoxide (CO) and carbon dioxide (CO₂) as compounds of carbon and oxygen that are produced at the time of arc discharge melting remain in the high-purity silica glass layer 59, they are regenerated as impurities at the time of pulling single crystal silicon, which can be a cause that lowers quality of the silicon. To suppress this problem, it is preferable to supply a clean atmospheric gas at a certain flow rate from the outside of the silica container 71 and release the gas in the container at a certain flow rate to appropriately ventilate the inside of the silica container during melting.

### (Second Embodiment)

A second embodiment according to the present invention will now be described. A description on the same matters as those in the first embodiment will be omitted.

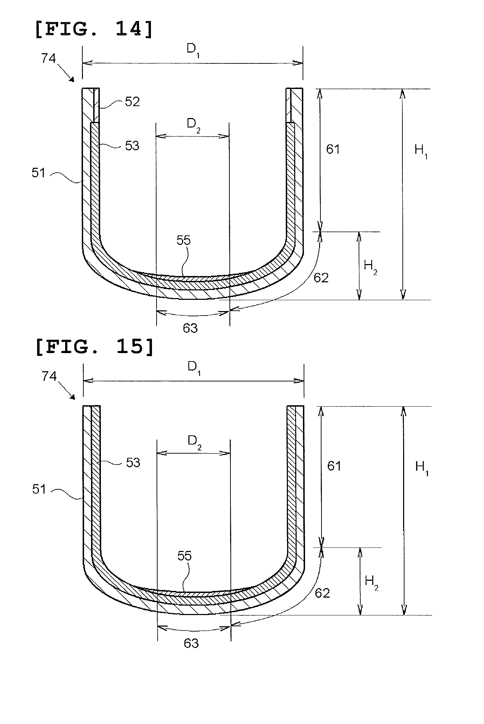

FIG. 14 and FIG. 15 show an example of a configuration of a silica container for pulling single crystal silicon according to a second embodiment of the present invention. As shown in FIG. 14, a silica container 74 according to the second embodiment of the present invention is formed into a crucible shape having rotation axis symmetry, and it has a straight body portion 61, a curved portion 62, and a bottom portion 63. At this time, 1/3 of an outer diameter (D₁) of the silica container 74 is determined as a diameter (D₂) of the bottom portion 63 for the convenience's sake. The bottom portion 63 is a circular portion. The straight body portion 61 is a cylindrical portion from an upper edge of the silica container 74 to a height portion that is 1/3 of a height (H₁) (a height H₁-H₂). Moreover, a portion from the height portion that is 1/3 of the height (H₁) of the silica container 74 to the bottom portion 63 (the height H₂) excluding the bottom portion 63 is determined as the curved portion 62.

The silica container 74 has a mixed silica layer 53 in an inner surface layer portion of the straight body portion 61, the curved portion 62, and the bottom portion 63 and has a bottom portion silica glass layer 55 on an inner surface of the mixed silica layer 53 on the bottom portion 63. The mixed silica layer 53 is constituted by mixing a phase in which a crystalline silica powder is fused and a phase in which an amorphous silica powder is fused in a granular texture like the first embodiment.

Additionally, in the silica container 74, a container outer side is made of opaque silica glass containing bubbles, and a container inner side is made of transparent silica glass. In the silica container 74, when such a two-layer structure is adopted, thermal uniformity in the silica container 74 can be assured at the time of using the silica container at a high temperature.

When the silicon melt is held in the silica container 74 as a raw material for pulling single crystal silicon, an inner surface of the silica container 74 undergoes etching (erosion) by the silicon melt due to a reaction between a silica component constituting the inner surface of the silica container 74 and the silicon melt (a melting reaction). At this time, in a portion which is not covered with the bottom portion silica glass layer 55 and where the mixed silica layer 53 is exposed, the phase in which the crystalline silica powder is fused has a smaller etching amount (an erosion amount) (i.e., a lower etching rate) than the phase in which the amorphous silica powder is fused, a portion having a granular structure in the phase in which the crystalline silica powder is fused becomes a convex portion, and the phase in which the amorphous silica powder is fused becomes a concave portion. This difference in etching effect enables forming fine irregularities of a surface of the mixed silica layer 53 (an interface with respect to the raw material silicon melt), and the surface turns to a scabrous rough surface. Due to generation of this rough surface, fine vibration is hard to occur on a melt surface of the molten silicon in the silica container at a high temperature, and the melt surface vibration that occurs like waves can be suppressed by the rough surface even if the fine vibration occurs. This is similar to a phenomenon that waves on the sea surface can be stopped by arranging wave dissipating blocks as tetrapods on a shore. As described above, the mixed silica layer 53 functions as a melt surface vibration suppression layer.

Further, even if the etching of the mixed silica layer 53 proceeds due to long-time use at a high temperature, since the mixed silica layer 53 has a certain thickness in the silica container 74 according to the second embodiment of the present invention, the fine irregularities (the rough surface) continue existing without being annihilated, and the melt surface vibration of the silicon melt can be suppressed for a long time. Since the effect of preventing the melt surface vibration continues for a long time, it particularly has a beneficial effect on multiple pulling (multi-pulling) of single crystal silicon.

The mixed silica layer 53 is formed to be placed at the inner surface layer portion of each of the straight body portion, the curved portion, and the bottom portion. The mixed silica layer 53 does not have to be formed in a certain range from an upper end of the straight body portion that is not in contact with the silicon melt as shown in FIG. 14, but it includes a position on the inner surface corresponding to an initial melt surface (an initial melt surface) when the silica container 74 holds the raw material silicon melt. Further, as shown in FIG. 15, the entire inner surface layer portion of the straight body portion, the curved portion, and the bottom portion in the silica container 74 may be formed as the mixed silica layer 53. It is to be noted that transparent silica glass (a "transparent silica glass 52" in FIG. 14) is not shown in FIG. 15 for the convenience's sake, but a portion made of the transparent silica glass is actually present in a portion placed in a container inner region in the mixed silica layer 53.

In the silica container 74, since the mixed silica layer 53 is exposed on the inner surface of the straight body portion 61 and the curved portion 62, it is possible to effectively suppress the melt surface vibration of the silicon melt in the initial stage (seeding, necking, shouldering, and others) and subsequent stages (pulling and tailing) of the method for pulling single crystal silicon. Since the melt surface vibration in all steps of pulling of the single crystal silicon can be suppressed, the present invention is suitable for multiple pulling (multi-pulling) of three or more ingots of single crystal silicon in particular.

The bottom portion silica glass layer 55 is formed on the inner surface of the bottom portion 63 of the silica container 74 because a diameter of the bottom portion 63 of the silica container 74 is close to a diameter of the single crystal silicon to be manufactured. If the surface of the mixed silica layer 53 is present on the bottom portion 63 of the silica container 74, irregularities are produced on the inner surface of the bottom portion 63 and the inner surface turns a scabrous rough surface at the time of manufacturing single crystal. When the silica glass reacts with the silicon melt in this state, a silicon oxide (SiO) gas is generated, gaseous bubbles grow on the irregular surface of the bottom portion 63, the gaseous bubbles move up into the silicon melt to be taken into the single crystal silicon that is in the growth process, and void defects called voids or pin holes are apt to be produced. Since the bottom portion 63 of the silica container 74 according to the second embodiment of the present invention is covered with the bottom portion silica glass layer 55, irregularities due to the mixed silica layer 55 are not produced on the inner surface of the bottom portion 63, and hence the gaseous bubbles do not grow. Therefore, generation of void defects called voids or pin holes in the single crystal silicon caused due to gaseous bubbles in the silicon melt can be suppressed.

In case of the silica container 74 according to the second embodiment of the present invention, the melt surface vibration can be suppressed in all steps of pulling single crystal silicon even in a large-diameter silica container having a diameter of 30 inches (75 cm) to a diameter of 54 inches (135 cm) for pulling large-diameter single crystal silicon having a diameter of 12 inches (30 cm) to a diameter of 18 inches (45 cm) in particular.

It is preferable for the mixed silica layer 53 to have a thickness of 2 mm or more in a wall thickness direction of the silica container 74. Although the mixed silica layer 53 is gradually etched and thinned during use of the silica container at a high temperature in a state that the raw material silicon melt is held, the melt surface vibration of the raw material silicon melt can be more assuredly suppressed for a long time by setting the thickness of the mixed silica layer 53 to 2 mm or more.

It is preferable for the mixed silica layer 53 to be made by using, as a raw material, a mixed powder of the crystalline silica powder having OH group concentration of 50 massppm or less and the amorphous silica powder having OH group concentration of 200 to 2000 ppm. When the mixed silica layer 53 is formed by using the mixed powder of the two types of silica powders having such a difference in OH group concentration as the raw material, a difference in etching rate relative to the silicon melt between the phase in which the crystalline silica powder is fused and the phase in which the amorphous silica powder is fused in the mixed silica layer 53 can be made more prominent, and the irregularities of the inner surface of the silica container 71 can be more assuredly formed. Although the OH group concentration of the phase in which the crystalline silica powder is fused corresponds to the OH group concentration of the crystalline silica powder and the OH group concentration of the phase in which the amorphous silica powder is fused corresponds to the OH group concentration of the amorphous silica powder, respectively, the silica container 74 is manufactured through a high-temperature step of approximately 1800°C or more, and hence some fluctuations are considered to occur. It is to be noted that, when the OH group concentration of the entire mixed silica layer 53 is measured, a value is approximately an average of the OH group concentration of both the types of raw material powder.

The mixed silica layer 53 is etched from its interface when the raw material silicon melt is held. Therefore, it is preferable to reduce an amount of impurity elements taken into the raw material silicon melt from the mixed silica layer 53 by increasing purity of the mixed silica layer 53. Specifically, it is preferable for concentration of each of impurity elements Li, Na, and K in the mixed silica layer 53 to be 100 massppb or less, concentration of each of Ca and Mg in the mixed silica layer 53 to be 50 massppb or less, and concentration of each of Ti, Cr, Fe, Ni, Cu, Zn, Zr, Mo, W, and Pb in the mixed silica layer 53 to be 20 massppb or less.

It is also desirable for the bottom portion silica glass layer 55 to have high purity and, specifically, it is preferable for concentration of each of impurity elements Li, Na, and K to be 50 massppb or less, and concentration of each of Ca and Mg to be 25 massppb or less, concentration of each of Ti, Cr, Fe, Ni, Cu, Zn, Zr, Mo, W, and Pb to be 10 massppb or less, and a thickness of this layer to be 200 to 2000 µm.

Further, although depending on use applications, it is preferable to set purity of any other portion (which may be also referred to as a "usual silica portion" hereinafter) than the mixed silica layer 53 and the bottom portion silica glass layer 55 in the silica container 74 shown in FIG. 14 and FIG. 15 to 99.99 mass% or more for pulling a solar single crystal and 99.999 mass% or more for pulling an LSI single crystal as silica (SiO₂) purity. OH group concentration and Al concentration of the usual silica portion can be set like the first embodiment.

In the following description, the above-described silica container 74 can be manufactured. A method for manufacturing a silica container for pulling single crystal silicon according to the second embodiment of the present invention will now be specifically explained hereinafter.

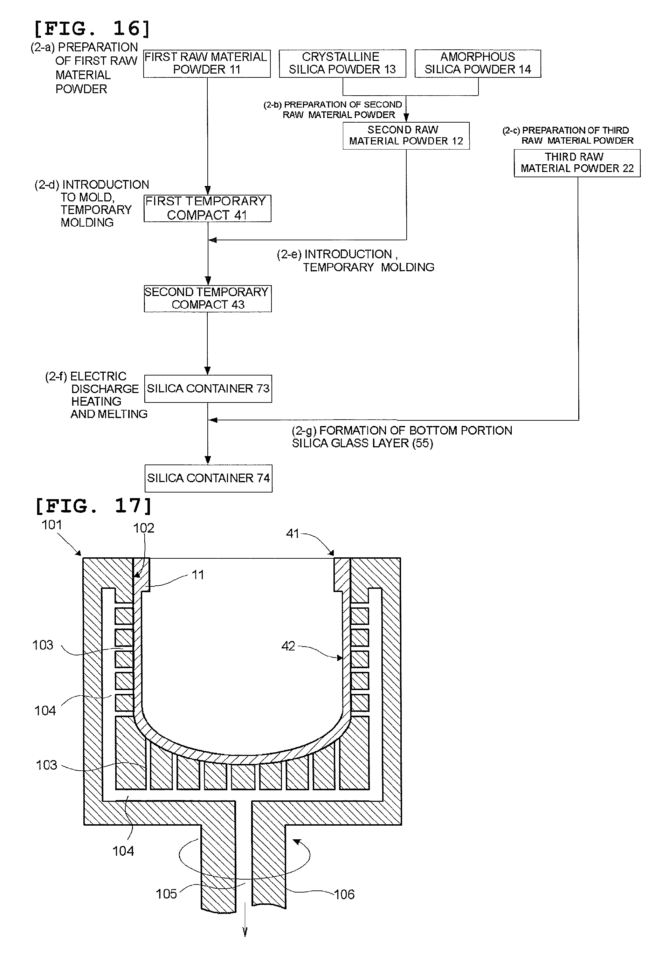

The method for manufacturing the silica container 74 shown in FIG. 14 and FIG. 15 will now be described with reference to FIG. 16.

As shown in (2-a), (2-b), and (2-c) in FIG. 16, a first raw material powder 11, a second raw material powder 2, and a third raw material powder 22 are prepared (a step (2-a), a step (2-b), and a step (2-c)). The first raw material powder 11 can be prepared before a later-described step of forming a first temporary compact 41, and the second raw material powder 12 can be prepared before a later-described step of forming a second temporary compact 43. The third raw material powder 22 can be prepared before a later-described step of forming a bottom portion silica glass layer 55.

### (Preparation of First Raw Material Powder 11)

The first raw material powder 11 serves as a material constituting a portion (the usual silica portion) other than the mixed silica layer 53 and the bottom portion silica glass layer 55 in the silica container 74. As the first raw material powder 11, a crystalline silica powder having a particle size of 10 to 1000 µm is prepared (the step (2-a)). The first raw material powder 11 can be prepared by, e.g., pulverizing and grading a silica rock as described above, but the present invention is not restricted thereto. Besides, various kinds of crystalline silica powder such as a high-purity synthetic cristobalite powder can be used.

A particle size of the first raw material powder 11 is determined as 10 to 1000 µm as described above. It is preferable to set this particle size to 50 to 500 µm. It is preferable to set silica purity (SiO₂) of the first raw material powder 11 to 99.99 mass% or more, desirably 99.999 mass% or more.

When the purity of the first raw material powder 11 is low (poor), to prevent impurity metal elements from moving and diffusing from the manufactured silica container 74 into the inner surface and into the contained silicon melt, certain amounts of Al and an OH group can be contained in the first raw material powder 11 like the first embodiment.

### (Preparation of Second Raw Material Powder)

The second raw material powder 12 serves as a material constituting the mixed silica layer 53. As the second raw material powder 12, a mixed powder of a crystalline silica powder 13 having a particle size of 50 to 2000 µm and an amorphous silica powder 14 having a particle size of 50 to 2000 µm is prepared (the step (2-b)). Preparation of the crystalline silica powder 13, preparation of the amorphous silica powder 14, and preparation of the second raw material powder 12 by mixing can be carried out like the first embodiment.

### (Preparation of Third Raw Material Powder)

The third raw material powder 22 serves as a raw material of the bottom portion silica glass layer 55. As the third raw material powder 22, crystalline silica powder having a particle size of 10 to 1000 µm is prepared (the step (2-c)). The third raw material powder 22 can be prepared by the same method as the first raw material powder 11. The third raw material powder 22 preferably has high purity. It is preferable to set the purity to 99.999 mass% or more of a silica component (SiO₂), or more specifically, set concentration of each of impurity elements Li, Na, and K to 50 massppb or less, concentration of each of Ca and Mg to 25 massppb or less, and concentration of each of Ti, Cr, Fe, Ni, Cu, Zn, Zr, Mo, W, and Pb to 10 massppb or less.

### (Formation of First Temporary Compact)

After preparing at least the first raw material powder 11, as shown in (2-d) in FIG. 16, the first raw material powder 11 is put into a mold having rotation symmetry, the powder is temporarily molded into a predetermined shape corresponding to an inner wall of the mold while rotating the mold, and a first temporary compact 41 made of the first raw material powder 11 is formed in the mold (a step (2-d)). Each of FIG. 7 and FIG. 8 is a cross-sectional view showing outline of the mold used for temporarily molding the first raw material powder 11. The mold 101 or 101' used in the second embodiment according to the present invention is made of, e.g., heat resisting ceramic such as graphite or alumina or a heat resisting metal having a cooling system, has the rotation symmetry, and can be rotated by a mold rotation motor (not shown). Furthermore, as shown in FIG. 7, pressure reducing holes 103 may be distributed and formed in an inner wall 102 of the mold 101. The pressure reducing holes 103 are continuous with a pressure reducing passage 104. Moreover, a pressure reducing passage 105 also runs through a rotary shaft 106 configured to rotate the mold 101, and vacuum drawing can be performed through this passage 105. In the second embodiment according to the present invention, such a mold 101' having no pressure reducing equipment as shown in FIG. 8 can be used. Pressure reducing holes are not formed in an inner wall 102' of this mold 101', and a pressure reducing passage is not formed in a rotary shaft 106'. Although a description will be given as to an example using the mold 101 shown in FIG. 7, the mold 101' shown in FIG. 8 can be likewise used except that pressure reduction is not performed.

At the step (2-c), the first raw material powder 11 is introduced to the inner wall 102 of the mold 101 depicted in FIG. 7, and the first raw material powder 11 is temporarily molded into a predetermined shape corresponding to the inner wall 102 of the mold 101 to provide the first temporary compact 41 (see FIG. 17). Specifically, the first raw material powder 11 is gradually put onto the inner wall 102 of the mold 101 while rotating the mold 101, and it is molded into a container shape having a predetermined thickness by using centrifugal force. Additionally, a wall thickness of the first temporary compact 41 may be adjusted to a predetermined amount by bringing a tabular inner mold (not shown) into contact with the rotating powder body from the inner side. At this time, a region used for introducing the second raw material powder 12 at a subsequent step is left. FIG. 17 shows an example of forming a recess 42 in the first temporary compact 41. Further, although a method for supplying the first raw material powder 11 into the mold 101 is not restricted in particular, for example, a hopper including an agitation screw and a measurement feeder can be used. In this case, the first raw material powder 11 filling the hopper is agitated with the use of the agitation screw and supplied while adjusting a supply amount by the measurement feeder.

Then, as shown in (2-e) in FIG. 16, the second raw material powder 12 is put into the recess 42 of the first temporary compact 41 formed in the mold 101 (a step (2-e)). As a result, a second temporary compact 43 having a portion made of the first raw material powder 11 and a portion made of the second raw material powder 12 is formed. A shape of the second temporary compact 43 is a shape corresponding to a shape of the silica container 74 to be manufactured, and a portion corresponding to the inner surface layer portion of the straight body portion, the curved portion, and the bottom portion of the silica container 74 to be manufactured is made of the second raw material powder 12. Although the second raw material powder 12 is put after the first temporary compact 41 is formed by using at least part of the first raw material powder 11, the entire second temporary compact 43 can be formed by putting part of the first raw material powder 11 even after putting the second raw material powder 12 as required.

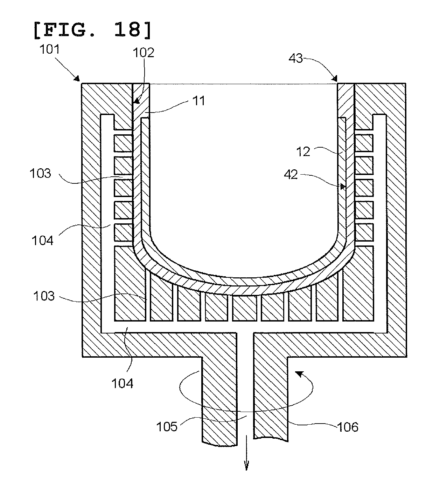

An example shown in FIG. 18 corresponds to the shape of the silica container 74 shown in FIG. 14. In this case, the second raw material powder 12 is put to the inside (the recess 42) of the first temporary compact 41. In case of manufacturing the silica container 74 shown in FIG. 15, the shape of the second temporary compact 43 is adjusted to turn to the shape corresponding to the silica container 74 shown in FIG. 15.

Then, as shown in (2-f) in FIG. 16, when heating is effected from the inside of the second temporary compact 43 by the electric discharge heating and melting method while rotating the mold 101, there is provided the silica container 73 in which the portion made of the second raw material powder 12 in the second temporary compact 43 is formed into the mixed silica layer 53 in which the phase in which the crystalline silica powder is fused and the phase in which the amorphous silica powder is fused are mixed in a granular texture, the container outer side is made of the opaque silica glass 51 containing bubbles, and the container inner side is made of the transparent silica glass 52 (the step (2-f)). It is preferable to heat the second temporary compact 43 based on the electric discharge heating and melting method while reducing a pressure from the outer side of the second temporary compact 43. Heating performed while reducing a pressure enables efficiently producing the opaque silica glass on the container outer side and the transparent silica glass on the container inner side.

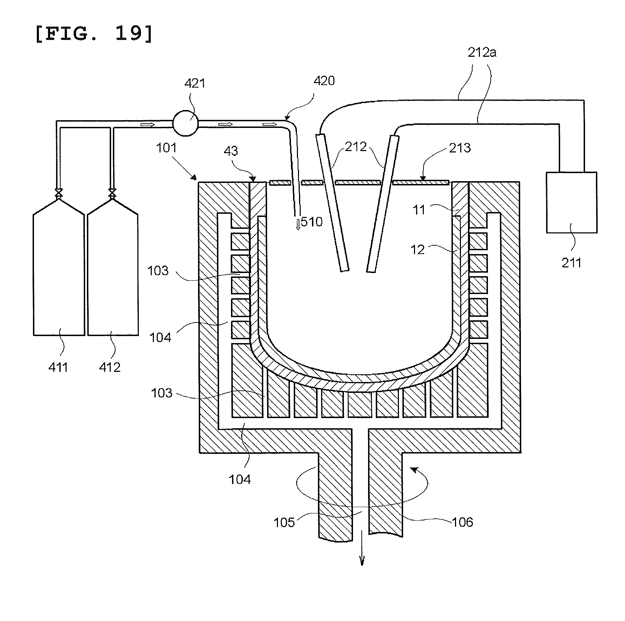

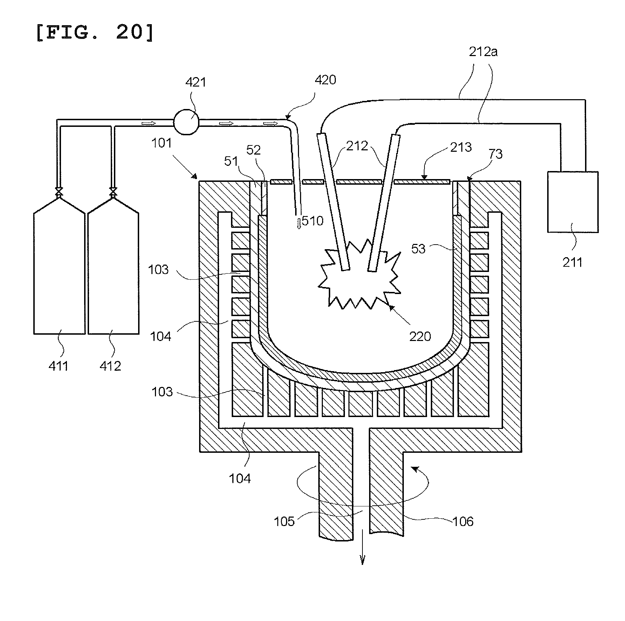

FIG. 19 and FIG. 20 specifically show a state of this step. An apparatus configured to produce this silica container 73 is constituted of the rotatable mold 101 having the rotation axis symmetry, a rotary motor (not shown), carbon electrodes 212 serving as a heat source of electric discharge heating and melting (which is also called arc melting or arc discharge melting), electric wires 212a, a high-voltage power supply unit 211, a lid 213, and others. The number of carbon electrodes 212 is generally two or three. As the power supply, an alternating current or a direct current can be used. Furthermore, the apparatus also includes constituent elements for adjusting an atmospheric gas supplied from the inside of the second temporary compact 43, e.g., a hydrogen gas supply cylinder 411, an inert gas supply cylinder 412, a mixed gas supply tube 420, a gas mixer, a flow rate adjuster 421, and others.

As a melting and sintering procedure of the second temporary compact 43, before starting voltage application between the carbon electrodes 212, first, it is preferable to start supplying a hydrogen containing gas from the inner side of the second temporary compact 43. Specifically, as shown in FIG. 19, a hydrogen gas is supplied from the hydrogen gas supply cylinder 411, an inert gas (e.g., nitrogen (N₂), argon (Ar), or helium (He)) is supplied from the inert gas supply cylinder 412, these gases are mixed, and the mixed gas is supplied from the inner side of the second temporary compact 43 through the mixed gas supply tube 420. It is to be noted that a void arrow indicated by reference numeral 510 shows a flow of the mixed gas.

Then, in a state that supply of the mixed gas is continued as described above, a degassing vacuum pump (not shown) is activated while rotating the mold 101 having the second temporary compact 43 therein at a fixed velocity, a pressure is reduced from the outer side of the second temporary compact 43 through the pressure reducing holes 103 and the pressure reducing passages 104 and 105, and voltage application between the carbon electrodes 212 is started.

When the arc discharge (denoted by reference numeral 220 in FIG. 20) is started between the carbon electrodes 212, an inner surface portion of the second temporary compact 43 reaches a melting temperature range (which is assumed to be approximately 1800 to 2000°C) of the silica powder, and melting starts from the most surface layer portion. When the most surface layer portion is molten, a pressure reduction degree of vacuum drawing using the degassing vacuum pump increases (a pressure is precipitously reduced), and a change into a molten silica glass layer proceeds from the inner side toward the outer side while degassing a dissolved gas of water, oxygen, or the like contained in the first raw material powder 11 and the second raw material powder 12.

Heating based on voltage application is continued until approximately inner one-third to one-half of the total thickness of the second temporary compact 43 is molten to turn to the transparent silica glass and approximately two-thirds to one-half that is the remainder of the outer part turns to sintered opaque silica.

For the purpose of reducing wear of the electrodes, the atmospheric gas inside the thick wall of the container at the time of this electric discharge heating and melting may contain an inert gas such as nitrogen (N₂), argon (Ar), or helium (He) as a main component, but using hydrogen containing gas as the atmospheric gas is preferable in this step in order to reduce the dissolved gas in the silica glass after melting as described above. This hydrogen containing gas can be a mixed gas consisting of, e.g., a hydrogen gas and an inert gas such as a nitrogen gas (N₂), argon (Ar), or helium (He). Setting a content ratio of the hydrogen gas (H₂) to 1 vol% or more is preferable, and setting the same to 1 to 10 vol% is more preferable. As a reason for this setting, it can be considered that, for example, an oxygen gas (O₂) that is hard to degas reacts with hydrogen to generate water (H₂O), water molecules have a higher diffusion coefficient than oxygen molecules, and hence they are apt to be released to the outside of the outer layer. Moreover, since the hydrogen gas (H₂) has a small molecular radius and a high diffusion coefficient, it is readily released to the outside of the outer layer even though it is contained in the atmospheric gas.

Through the above-described steps, there is manufactured the silica container 73 in which the mixed silica layer 53 is provided, the container outer side is made of the opaque silica glass containing bubbles, and the container inner side is made of the transparent silica glass (see FIG. 20).

Subsequently, as shown in (2-g) in FIG. 16, the bottom portion silica glass layer 55 is formed on the bottom portion of the silica container 73, thereby manufacturing the silica container 74 according to the second embodiment of the present invention (a step (2-g)). At this step, the third raw material powder (the raw material powder for forming the bottom portion silica glass layer) 22 is molten by the electric discharge heating and melting method while spreading the third raw material powder 22 from the upper side of the silica container 73, and the molten third raw material powder 22 is allowed to adhere to the inner surface portion of the bottom portion of the silica container 73, thereby forming the bottom portion silica glass layer 55. It is preferable to form the bottom portion silica glass layer 55 while determining concentration of each of impurity elements Li, Na, and K to be 50 massppb or less, concentration of each of Ca and Mg to be 25 massppb or less, concentration of each of Ti, Cr, Fe, Ni, Cu, Zn, Zr, Mo, W, and Pb to be 10 massppb or less, and a thickness to be 200 to 2000 µm.

As a result, the silica container 74 shown in FIG. 14 can be manufactured. Although the basic method for forming the bottom portion silica glass layer 55 based on this step is similar to contents described in, e.g., Patent Literature 1 and Patent Literature 2, the bottom portion silica glass layer 55 is formed on the bottom portion of the inner surface of the silica container 73 alone in the second embodiment according to the present invention.

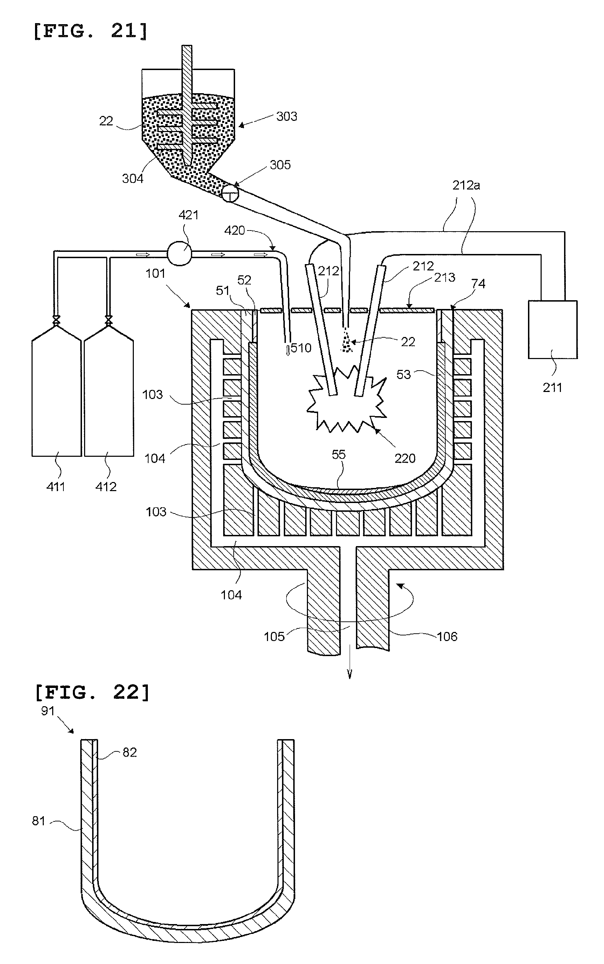

As substantially similar to the step (2-f), the apparatus shown in FIG. 21 that forms the bottom portion silica glass layer 55 on the inner surface portion of the bottom portion of the silica container 73 is constituted of the rotatable mold 101 in which the silica container having rotation axis symmetry is installed, the rotary motor (not shown), a raw material powder hopper 303 having the third raw material powder 22 therein, an agitation screw 304, a measurement feeder 305, the carbon electrodes 212 serving as a heat source of the electric discharge heating and melting, electric wires 212a, a high-voltage power supply unit 211, a lid 213, and others. Furthermore, in case of adjusting an atmospheric gas, like the step (2-f), the apparatus may further include the hydrogen gas supply cylinder 411, the inert gas supply cylinder 412, a mixed gas supply tube 420, a gas mixer, a flow rate adjuster 421, and others. Such an apparatus can be continuously used from the step (2-f).

As a method for forming the bottom portion silica glass layer 55, first, the mold 101 is set to a predetermined rotation velocity, a high voltage is gradually applied from the high-voltage power supply unit 211 and, at the same time, the third raw material powder 22 from the raw material hopper 303 is gradually spread from the upper side of the silica container 73. At this time, electric discharge is started between the carbon electrodes 212, the melting temperature range (which is assumed to be approximately 1800 to 2000°C) of the silica powder is formed in the silica container 73, and hence the spread third raw material powder 22 turns to molten particles of silica and adheres to the inner surface of the silica container 73. The carbon electrodes 212, a raw material powder input opening, and the lid 213 disposed at an upper opening portion of the silica container 73 function as a mechanism that changes positions relative to the silica container 71 to some extent, and changing the positions enables forming the bottom portion silica glass layer 55 with a predetermined thickness at a predetermined position on the bottom portion of the silica container 73.

For the purpose of reducing wear of the electrodes, the atmospheric gas in the silica container 73 during the arc discharge melting may contain an inert gas such as nitrogen (N₂), argon (Ar), or helium (He) as a main component, but using a mixed atmosphere containing 1 to 10 vol% of a hydrogen gas (H₂) enables obtaining the bottom portion silica glass layer 55 containing less bubbles.

When carbon fine particles and carbon monoxide (CO) and carbon dioxide (CO₂) as compounds of carbon and oxygen that are generated at the time of arc discharge melding remain in the bottom portion silica glass layer 55, they are regenerated as impurities at the time of pulling single crystal silicon, which can be a cause that lowers quality of the silicon. To suppress this problem, it is preferable to supply a clean atmospheric gas at a certain flow rate from the outside of the silica container 73 and release the gas in the container at a certain flow rate to appropriately ventilate the inside of the silica container during melting.

### Examples

Although the present invention will now be more specifically explained based on examples and comparative examples of the present invention, the present invention is not restricted by them.

### (Example 1)

Based on the steps (1-a) to (1-e) shown in FIG. 6, a silica container 71 for pulling single crystal silicon depicted in FIG. 1 was manufactured. As the first raw material powder 11, natural quartz powder (A) having a particle size of 50 to 500 µm and purity of 99.999 mass% was prepared. Impurity concentration, OH group concentration, and an H₂O molecule release amount of this natural quartz powder (A) are shown in Table 9. As the second raw material powder 12, a mixed powder of a crystalline silica powder 13 as a natural quartz powder (B) and an amorphous silica powder 14 as synthetic silica glass powder (A) was prepared. The amorphous silica powder 14 is a synthetic silica glass powder prepared by the oxyhydrogen flame hydrolysis method of silicon tetrachloride SiCl₄. Impurity element concentration, OH group concentration, and an H₂O molecule release amount of each of the natural quartz powder (B) and the synthetic silica glass powder (A) are shown in Table 10. A mixing ratio of the crystalline silica powder 13 and the amorphous silica powder 14 was set to 50:50 (mass% ratio).

The first raw material powder 11 and the second raw material powder 12 were put into a graphite mold 101 a graphite mold 101 shown in FIG. 7, FIG. 9 and FIG. 10 while rotating the graphite mold 101, thereby providing a second temporary compact 43. Subsequently, with the use of the apparatus shown in FIG. 11 and FIG. 12, a dried mixed gas containing 95 vol% of N₂ and 5 vol% of H₂ was used as the inner atmosphere of the second temporary compact 43, electric discharge heating and melting was performed in the second temporary compact 43 while effecting aspiration and decompression from an outer peripheral portion, thereby producing the silica container 71.

### (Example 2)

A silica container 71 shown in FIG. 1 was manufactured by the same method as Example 1 except that synthetic silica glass powder (B) shown in Table 10 was used as an amorphous silica powder 14 constituting a second raw material powder 12.

### (Example 3)

A silica container 71 shown in FIG. 1 was manufactured by the same method as Example 1 except that synthetic silica glass powder (C) shown in Table 10 was used as an amorphous silica powder 14 constituting a second raw material powder 12.

### (Example 4)

Although a silica container 71 shown in FIG. 1 was manufactured basically in the same manner as Example 3, a mixing ratio of the crystalline silica powder 13 and the amorphous silica powder 14 was set to 30:70 (mass% ratio).

### (Example 5)

A high-purity silica glass layer 59 (the step (1-f) in FIG. 6) was formed on a bottom portion of a silica container 71 manufactured by the same method as Example 3, and a silica container 72 shown in FIG. 2 was manufactured. As a raw material powder for the high-purity silica glass layer 59 at this time, synthetic cristobalite powder (A) having impurity concentration and OH group concentration shown in Table 11 was used.

### (Example 6)

First, a silica container 71 was manufactured by the same method as Example 2 except that a melting atmospheric gas at the time of the electric discharge heating and melting was a mixed gas containing 50 vol% of N₂, 10 vol% of H₂, and 40 vol% of He. A high-purity silica glass layer 59 (the step (1-f) in FIG. 6) was formed on a bottom portion of this silica container 71 while using a melting atmospheric gas containing 50 vol% of N₂, 10 vol% of H₂, and 40 vol% of He, and a silica container 72 shown in FIG. 2 was manufactured. As a raw material powder (high-purity silica glass layer forming raw material powder 21) for the high-purity silica glass layer 59 at this time, synthetic cristobalite powder (A) having impurity concentration and OH group concentration shown in Table 11 was used.

### (Example 7)

Although a silica container 71 was manufactured basically in the same manner as Example 3, a thickness of a mixed silica layer 53 was set to 2 mm.

### (Example 8)

A silica container 71 having the conformation shown in FIG. 3 was manufactured. Other conditions are the same as those of Example 3.

### (Example 9)

A silica container 71 shown in FIG. 1 was manufactured by the same method as Example 1 except that an amorphous silica powder 14 constituting a second raw material powder 12 was synthetic silica glass powder (D) shown in Table 10.

### (Example 10)

A silica container 72 shown in FIG. 2 was manufactured by the same method as Example 6 except that an amorphous silica powder 14 constituting a second raw material powder 12 was synthetic silica glass powder (D) shown in Table 10.

### (Example 11)

Based on the steps (1-a) to (1-e) shown in FIG. 6, a silica container 71 for pulling single crystal silicon depicted in FIG. 5, i.e., a silica container having a mixed silica layer 53 on an inner surface layer portion of a straight body portion 61 and a curved portion 62 was manufactured. As a first raw material powder 11, natural quartz powder (A) having a particle size of 50 to 500 µm and purity of 99.999 mass% was prepared. Impurity concentration of this natural quartz powder (A) is shown in Table 9. As a second raw material powder 12, a mixed powder of a crystalline silica powder 13 as natural quartz powder (C) and an amorphous silica powder 14 as synthetic silica glass powder (E) was prepared. The natural quartz power (C) of the crystalline silica powder 13 is obtained by performing the purity raising processing to natural quartz powder (B), and the amorphous silica powder 14 is a synthetic silica glass powder prepared by the oxyhydrogen flame hydrolysis method of silicon tetrachloride SiCl₄. Impurity element concentration, OH group concentration, and an H₂O molecule release amount of each of the natural quartz powder (C) and the synthetic silica glass powder (E) are shown in Table 12 and Table 13. A mixing ratio of the crystalline silica powder 13 and the amorphous silica powder 14 was set to 60:40 (mass% ratio).

### (Example 12)

A silica container 71 shown in FIG. 5 was manufactured by the same method as Example 11 except that synthetic silica glass powder (F) shown in Table 13 was used as an amorphous silica powder 14 constituting a second raw material powder 12 and a mixing ratio of the crystalline silica powder 13 and the amorphous silica powder 14 was set to 60:40 (mass% ratio).

### (Example 13)

A silica container 71 shown in FIG. 5 was manufactured by the same method as Example 12 except that synthetic silica glass powder (G) shown in Table 13 was used as an amorphous silica powder 14 constituting a second raw material powder 12 and a mixed gas containing 93 vol% of N₂ and 7 vol% of H₂ was used as a melting atmospheric gas at the time of the electric discharge heating and melting.

### (Example 14)

A silica container 71 shown in FIG. 5 was manufactured by the same method as Example 13 except that a mixing ratio of the crystalline silica powder 13 and the amorphous silica powder 14 was set to 30:70 (mass% ratio).

### (Comparative Example 1)

A silica container was manufactured with the use of a natural quartz powder as a raw material powder by the low-pressure arc discharge melting method. This silica container does not have a portion corresponding to the mixed silica layer 53 according to the present invention, a container outer side thereof is made of opaque silica glass containing bubbles, and a container inner side thereof is made of transparent silica glass.

### (Comparative Example 2)

First, a silica container was manufactured with the use of a natural quartz powder as a raw material powder by a normal pressure arc melting method. Then, a synthetic cristobalite powder was used as a raw material, and a high-purity silica glass layer was formed over the entire inner surface of this silica container by the normal pressure arc melting method while spreading this raw material powder from the upper side of the silica container.

### [Evaluation Method in Examples and Comparative Examples]

Physical properties and characteristics of the raw material powders used in each of Examples 1 to 14 and Comparative Examples 1 and 2 and the silica container manufactured in them were evaluated as follows.

### Measurement of Particle size of Each Raw material Powder:

Observation of a two-dimensional shape and measurement of an area were performed with respect to each raw material powder with the use of an optical microscope or an electron microscope. Then, a shape of a particle was assumed to be a perfect circle, and a diameter was obtained from an area value of this shape by a calculation. This technique was statistically repeatedly performed, and values in the particle size range (the raw material powder of 99 mass% or more is included in this range) are shown in Table 1 to Table 8.

### Measurement of Layer Thickness of Silica Container:

Each silica container was cut by a cutter, and a cross section was measured by a scale to obtain a thickness.

### Measurement of OH Group Concentration:

OH group concentration was measured by the infrared absorption spectrophotometry. Conversion into the OH group concentration is based on the following reference literature.

Dodd, D. M. and Fraser, D. B. (1966) Optical determination of OH in fused silica. Journal of Applied Physics, vol. 37, P. 3911.

### Analysis of Impurity Metal Element Concentration:

The analysis was performed based on inductively coupled plasma atomic emission spectroscopy (ICP-AES) or inductively coupled plasma mass spectroscopy (ICP-MS) when the impurity metal element concentration was relatively low (glass had high purity), or the analysis was performed based on atomic absorption spectrophotometry (AAS) when the impurity metal element concentration was relatively high (glass has low impurity). The concentration analysis was conducted with respect to 15 elements, i.e., alkali metal elements Li, Na, and K, alkaline-earth metal elements Ca and Mg, and transition metal elements Ti, Cr, Fe, Ni, Cu, Zn, Zr, Mo, W, and Pb.

### Method for Measuring H₂O Gas Release Amount

Approximately 2 g of each raw material powder were sampled, and the sample was installed in a vacuum chamber, and a gas release amount at 1000°C under vacuum was measured. Particulars are based on the following literature.

Nasu, S. et al. (1990) "Gas release of various kinds of vitreous silica", Journal of Illuminating Engineering Institute of Japan, vol. 74, No. 9, pp. 595-600.

### Evaluation of Melt Surface Vibration when Pulling Single Crystal Silicon:

Metal polysilicon having purity of 99.99999999 mass% was put into a silica container having a diameter of 800 mm (32 inches), and a temperature was raised to provide a silicon melt. At this time, in Examples 1 to 10, a molten silicon surface was set to be present at a substantially central part of the mixed silica layer (a belt-like inner peripheral layer) in the silica container. An argon (Ar) gas 100% atmosphere was formed in a CZ apparatus, a seed crystal of single crystal silicon was moved down while rotating, and seeding, necking and shouldering were advanced. The evaluation of degrees of the melt surface vibration were as follows.
- Melt surface vibration did not occur, and seeding, necking, and shouldering were all smoothly performed. ○ (good)
- Melt surface vibration slightly occurred, but shouldering was eventually performed by repeating steps of seeding and necking more than once. Δ (slightly good)
- Melt surface vibration was intensive, and seeding, necking, and shouldering were not able to be performed. × (bad)

### Evaluation of Continuous Pulling (Multiple Pulling) of Single Crystal Silicon:

Metal polysilicon having purity of 99.99999999 mass% was put into the manufactured silica container, a temperature was raised to provide a silicon melt, and then pulling of single crystal silicon was repeatedly carried out for three times multi-pulling to be evaluated as a success rate of growth of the single crystal silicon. As pulling conditions, an argon (Ar) gas 100% atmosphere was formed in a pulling apparatus (the CZ apparatus), a pulling rate was set to 1 mm/minute, a single crystal silicon dimension was a diameter of 300 mm and a length of 900 mm, and an operating time of each pulling of the single crystal silicon was approximately 30 hours. Classification of the success rate of the growth of the single crystal silicon repeated for three times is as follows.
- Three single crystal silicon ingots were successfully pulled. ○ (good)
- Two single crystal silicon ingots were successfully pulled. Δ (slightly good)
- One single crystal silicon ingot was pulled. × (bad).

### Evaluation of Voids and Pin Holes:

Voids and pin holes in the pulled single crystal silicon were evaluated with respect to Examples 1 to 14 as follows. In the continuous pulling of the single crystal silicon, 200 double-side polished silicon wafers each having a diameter of 300 mm and a thickness of 200 µm were prepared from an arbitrary region of a first ingot of single crystal silicon after each single crystal silicon multi-pulling. Then, the number of voids an pin holes present on both surfaces of each silicon wafer were measured by a particle detector, numerical processing was statistically performed, and the number of defect-free silicon wafers in every 200 silicon wafers was obtained. As a result, the following evaluation was performed in accordance with the number of silicon wafers from which voids and pin holes were not detected. However, a diameter of each of detectable voids and pin holes was 50 µm or more.
- The number of defect-free silicon wafers: 200 to 199 ○ (good)
- The number of defect-free silicon wafers: 198 to 197 Δ (slightly good)
- The number of defect-free silicon wafers: 196 or less × (bad)

Manufacturing conditions, measured physical property values, and evaluation results of the respective silica containers manufactured in Examples 1 to 14 and Comparative Examples 1 and 2 were organized and shown in the following Tables 1 to 13.

**[Table 1]**

| Example number | | Example 1 | Example 2 |
|---|---|---|---|
| First raw material powder | | Purity: 99.999 mass% | Purity: 99.999 mass% |
| | | Natural quartz powder (A) | Natural quartz powder (A) |
| | | Particle size:50 to 500 µm | Particle size: 50 to 500 µm |
| Second raw material powder (crystalline silica) | | Natural quartz powder (B) | Natural quartz powder (B) |
| | | 50 mass% | 50 mass% |
| | | Particle size:500 to 1000 µm | Particle size: 500 to 1000 µm |
| Second raw material powder (amorphous silica) | | Synthetic silica glass powder (A) | Synthetic silica glass powder (B) |
| | | 50 mass% | 50 mass% |
| | | Particle size: 500 to 1000 µm | Particle size: 500 to 1000 µm |
| Third raw material powder (high-purity silica) | | Nil | Nil |
| Melting method | | Low-pressure arc discharge melting method | Low-pressure arc discharge melting method |
| Melting atmospheric gas | | N₂ 95 vol.%, H₂ 5 vol.% | N₂ 95 vol.%, H₂ 5 vol.% |
| Container dimension: outer diameter, height (mm) | | Diameter 800 × height 380 | Diameter 800 × height 380 |
| Physical properties of straight body portion | Color tone | White opaque on outer side/colorless and transparent on inner side | White opaque on outer side/colorless and transparent on inner side |
| | Thickness (mm) | 17 | 17 |
| | Width, thickness (mm) of mixed silica layer (belt-like inner peripheral layer) | Width 150 × Thickness 7 (FIG. 1) | Width 150× Thickness 7 (FIG. 1) |
| | OH group in mixed silica layer (ppm) | 150 (transparent portion) | 310 (transparent portion) |
| | OH group in other portion than mixed silica layer (ppm) | 15 (transparent portion) | 15 (transparent portion) |
| Physical properties of bottom portion | Color tone | White opaque on outer side/colorless and transparent on inner side | White opaque on outer side/colorless and transparent on inner side |
| | Thickness (mm) | 17 | 17 |
| | OH group (ppm) | 15 (transparent portion) | 15 (transparent portion) |
| | Thickness of high-purity silica glass layer (µm) | 0 | 0 |
| Evaluation | Melt surface vibration | Δ | ○ |
| | Multi-pulling of single crystal silicon | ○ | ○ |

**[Table 2]**

| Example number | | Example 3 | Example 4 |
|---|---|---|---|
| First raw material powder | | Purity: 99.999 mass% | Purity: 99.999 mass% |
| | | Natural quartz powder (A) | Natural quartz powder (A) |
| | | Particle size: 50 to 500 µm | Particle size: 50 to 500 µm |
| Second raw material powder (crystalline silica) | | Natural quartz powder (B) | Natural quartz powder (B) |
| | | 50 mass% | 30 mass% |
| | | Particle size: 500 to 1000 µm | Particle size: 500 to 1000 µm |
| Second raw material powder (amorphous silica) | | Synthetic silica glass powder (C) | Synthetic silica glass powder (C) |
| | | 50 mass% | 70 mass% |
| | | Particle size: 500 to 1000 µm | Particle size: 500 to 1000 µm |
| Third raw material powder (high-purity silica) | | Nil | Nil |
| Melting method | | Low-pressure arc discharge melting method | Low-pressure arc discharge melting method |
| Melting atmospheric gas | | N₂ 95vol.%, H₂ 5vol.% | N₂ 95vol.%, H₂ 5vol.% |
| Container dimension: outer diameter, height (mm) | | Diameter 800 × height 380 | Diameter 800 × height 380 |
| Physical properties of straight body portion | Color tone | White opaque on outer side/colorless and transparent on inner side | White opaque on outer side/colorless and transparent on inner side |
| | Thickness (mm) | 17 | 17 |
| | Width, thickness (mm) of mixed silica layer (belt-like inner peripheral layer) | Width 150 × Thickness 7 (FIG. 1) | Width 150 × Thickness 7 (FIG. 1) |
| | OH group in mixed silica layer (ppm) | 750 (transparent portion) | 1000 (transparent portion) |
| | OH group in other portion than mixed silica layer (ppm) | 16 (transparent portion) | 17 (transparent portion) |
| Physical properties of bottom portion | Color tone | White opaque on outer side/colorless and transparent on inner side | White opaque on outer side/colorless and transparent on inner side |
| | Thickness (mm) | 17 | 17 |
| | OH group (ppm) | 16 (transparent portion) | 17 (transparent portion) |
| | Thickness of high-purity silica glass layer (µm) | 0 | 0 |
| Evaluation | Melt surface vibration | ○ | Δ |
| | Multi-pulling of single crystal silicon | ○ | ○ |

**[Table 3]**

| Example number | | Example 5 | Example 6 |
|---|---|---|---|
| First raw material powder | | Purity: 99.999 mass% | Purity: 99.999 mass% |
| | | Natural quartz powder (A) | Natural quartz powder (A) |
| | | Particle size: 50 to 500 µm | Particle size: 50 to 500 µm |
| Second raw material powder (crystalline silica) | | Natural quartz powder (B) | Natural quartz powder (B) |
| | | 50 mass% | 50 mass% |
| | | Particle size: 500 to 1000 µm | Particle size: 500 to 1000 µm |
| Second raw material powder (amorphous silica) | | Synthetic silica glass powder (C) | Synthetic silica glass powder (B) |
| | | 50 mass% | 50 mass% |
| | | Particle size: 500 to 1000 µm | Particle size: 500 to 1000 µm |
| Third raw material powder (high-purity silica) | | Synthetic cristobalite powder (A) | Synthetic cristobalite powder (A) |
| | | Particle size: 100 to 300 µm | Particle size: 100 to 300 µm |
| Melting method | | Low-pressure arc discharge melting method | Low-pressure arc discharge melting method |
| Melting atmospheric gas | | N₂ 95vol.%, H₂ 5vol.% | N₂ 50vol.%, H₂ 10 vol.%, He 40vol.% |
| Container dimension: outer diameter, height (mm) | | Diameter 800 × Height 380 | Diameter 800 × Height 380 |
| Physical properties of straight body portion | Color tone | White opaque on outer side/colorless and transparent on inner side | White opaque on outer side/colorless and transparent on inner side |
| | Thickness (mm) | 17 | 17 |
| | Width, thickness of mixed silica layer (belt-like inner peripheral layer) (mm) | Width 150x Thickness 7 (FIG. 2) | Width 150× Thickness 7 (FIG. 2) |
| | OH group in mixed silica layer (ppm) | 750 (transparent portion) | 290 (transparent portion) |
| | OH group in other portion than mixed silica layer (ppm) | 16 (transparent portion) | 13 (transparent portion) |
| Physical properties of bottom portion | Color tone | White opaque on outer side/colorless and transparent on inner side | White opaque on outer side/colorless and transparent on inner side |
| | Thickness (mm) | 17 | 17 |
| | OH group (ppm) | 15 (transparent portion) | 10 (transparent portion) |
| | Thickness of High-purity silica glass layer (µm) | 650 | 300 |
| Evaluation | Melt surface vibration | ○ | ○ |
| | Multi-pulling of single crystal silicon | ○ | ○ |

**[Table 4]**

| Example number | | Example 7 | Example 8 |
|---|---|---|---|
| First raw material powder | | Purity: 99.999 mass% | Purity: 99.999 mass% |
| | | Natural quartz powder (A) | Natural quartz powder (A) |
| | | Particle size: 50 to 500 µm | Particle size: 50 to 500 µm |
| Second raw material powder (crystalline silica) | | Natural quartz powder (B) | Natural quartz powder(B) |
| | | 50 mass% | 50 mass% |
| | | Particle size: 500 to 1000 µm | Particle size: 500 to 1000 µm |
| Second raw material powder (amorphous silica) | | Synthetic silica glass powder (C) | Synthetic silica glass powder (C) |
| | | 50 mass% | 50 mass% |
| | | Particle size: 500 to 1000 µm | Particle size: 500 to 1000 µm |
| Third raw material powder (high-purity silica) | | Nil | Nil |
| Melting method | | Low-pressure arc discharge melting method | Low-pressure arc discharge melting method |
| Melting atmospheric gas | | N₂ 95vol.%, H₂ 5 vol.% | N₂ 95vol.%, H₂ 5 vol.% |
| Container dimension: outer diameter, height (mm) | | Diameter 800 × Height 380 | Diameter 800 × Height 380 |
| Physical properties of straight body portion | Color tone | White opaque on outer side/colorless and transparent on inner side | White opaque on outer side/colorless and transparent on inner side |
| | Thickness (mm) | 17 | 17 |
| | Width, thickness of mixed silica layer (belt-like inner peripheral layer) (mm) | Width 100 × Thickness 2 (FIG. 1) | Width 100 × Thickness 17 (FIG. 3) |
| | OH group in mixed silica layer (ppm) | 750 (transparent portion) | 750 (transparent portion) |
| | OH group in other portion than mixed silica layer (ppm) | 18 (transparent portion) | 17 (transparent portion) |
| Physical properties of bottom portion | Color tone | White opaque on outer side/colorless and transparent on inner side | White opaque on outer side/colorless and transparent on inner side |
| | Thickness (mm) | 17 | 17 |
| | OH group (ppm) | 16 (transparent portion) | 16 (transparent portion) |
| | Thickness of high-purity silica glass layer (µm) | 0 | 0 |
| Evaluation | Melt surface vibration | Δ | ○ |
| | Multi-pulling of single crystal silicon | ○ | ○ |

**[Table 5]**

| Example number | | Example 9 | Example 10 |
|---|---|---|---|
| First raw material powder | | Purity: 99.999 mass% | Purity: 99.999 mass% |
| | | Natural quartz powder (A) | Natural quartz powder (A) |
| | | Particle size: 50 to 500 µm | Particle size: 50 to 500 µm |
| Second raw material powder (crystalline silica) | | Natural quartz powder (B) | Natural quartz powder (B) |
| | | 50 mass% | 50 mass% |
| | | Particle size: 500 to 1000 µm | Particle size: 500 to 1000 µm |
| Second raw material powder (amorphous silica) | | Synthetic silica glass powder (D) | Synthetic silica glass powder (D) |
| | | 50 mass% | 50 mass% |
| | | Particle size: 500 to 1000 µm | Particle size: 500 to 1000 µm |
| Third raw material powder (high-purity silica) | | Nil | Synthetic cristobalite powder (A) |
| | | | Particle size: 100 to 300 µm |
| Melting method | | Low-pressure arc discharge melting method | Low-pressure arc discharge melting method |
| Melting atmospheric gas | | N₂ 95 vol.%, H₂ 5 vol.% | N₂ 95 vol.%, H₂ 5 vol.% |
| Container dimension: outer diameter, height (mm) | | Diameter 800 × height 380 | Diameter 800 × height 380 |
| Physical properties of straight body portion | Color tone | White opaque on outer side/colorless and transparent on inner side | White opaque on outer side/colorless and transparent on inner side |
| | Thickness (mm) | 17 | 17 |
| | Width, thickness of mixed silica layer (belt-like inner peripheral layer) (mm) | Width 150 × Thickness 7 (FIG. 1) | Width 150× Thickness 7 (FIG. 2) |
| | OH group in mixed silica layer (ppm) | 16 (transparent portion) | 14 (transparent portion) |
| | OH group in other portion than mixed silica layer (ppm) | 16 (transparent portion) | 14 (transparent portion) |
| Physical properties of bottom portion | Color tone | White opaque on outer side/colorless and transparent on inner side | White opaque on outer side/colorless and transparent on inner side |
| | Thickness (mm) | 17 | 17 |
| | OH group (ppm) | 14 (transparent portion) | 13 (transparent portion) |
| | Thickness of high-purity silica glass layer (µm) | 0 | 300 |
| Evaluation | Melt surface vibration | Δ | Δ |
| | Multi-pulling of single crystal silicon | ○ | ○ |

**[Table 6]**

| Example number | | Example 11 | Example 12 |
|---|---|---|---|
| First raw material powder | | Purity: 99.999 mass% | Purity: 99.999 mass% |
| | | Natural quartz powder (A) | Natural quartz powder (A) |
| | | Particle size: 50 to 500 µm | Particle size: 50 to 500 µm |
| Second raw material powder (crystalline silica) | | Natural quartz powder (C) | Natural quartz powder (C) |
| | | 60 mass% | 60 mass% |
| | | Particle size: 500 to 1000 µm | Particle size: 500 to 1000 µm |
| Second raw material powder (amorphous silica) | | Synthetic silica glass powder (E) | Synthetic silica glass powder (F) |
| | | 40 mass% | 40 mass% |
| | | Particle size: 500 to 1000 µm | Particle size: 500 to 1000 µm |
| Third raw material powder (high-purity silica) | | Nil | Nil |
| Melting method | | Low-pressure arc discharge melting method | Low-pressure arc discharge melting method |
| Melting atmospheric gas | | N₂ 95 vol.%, H₂ 5 vol.% | N₂ 95 vol.%, H₂ 5 vol.% |
| Container dimension: outer diameter, height (mm) | | Diameter 800 × Height 380 (FIG. 5) | Diameter 800 × Height 380 (FIG. 5) |
| Physical properties of straight body portion | Color tone | White opaque on outer side/colorless and transparent on inner side | White opaque on outer side/colorless and transparent on inner side |
| | Total thickness (mm) | 17 | 17 |
| | Thickness of mixed silica layer (belt-like inner peripheral layer) (mm) | 7 | 7 |
| | OH group of mixed silica layer (ppm) | 120 (transparent portion) | 300 (transparent portion) |
| | OH group in other portion than mixed silica layer (ppm) | 25 (semitransparent portion) | 25 (semitransparent portion) |
| Physical properties of bottom portion | Color tone | White opaque on outer side/colorless and transparent on inner side | White opaque on outer side/colorless and transparent on inner side |
| | Total thickness (mm) | 17 | 17 |
| | OH group (ppm) | 20 (transparent portion) | 20 (transparent portion) |
| | Thickness of high-purity silica glass layer (µm) | 0 | 0 |
| Evaluation | Melt surface vibration | ○ | ○ |
| | Multi-pulling of single crystal silicon | ○ | ○ |
| | Void and pin hole | ○ | ○ |

**[Table 7]**

| Example number | | Example 13 | Example 14 |
|---|---|---|---|
| First raw material powder | | Purity: 99.999 mass% | Purity: 99.999 mass% |
| | | Natural quartz powder (A) | Natural quartz powder (A) |
| | | Particle size: 50 to 500 µm | Particle size: 50 to 500 µm |
| Second raw material powder (crystalline silica) | | Natural quartz powder (C) | Natural quartz powder (C) |
| | | 60 mass% | 30 mass% |
| | | Particle size: 500 to 1000 µm | Particle size: 500 to 1000 µm |
| Second raw material powder (amorphous silica) | | Synthetic silica glass powder (G) | Synthetic silica glass powder (G) |
| | | 40 mass% | 70 mass% |
| | | Particle size: 500 to 1000 µm | Particle size: 500 to 1000 µm |
| Third raw material powder (high-purity silica) | | Nil | Nil |
| Melting method | | Low-pressure arc discharge melting method | Low-pressure arc discharge melting method |
| Melting atmospheric gas | | N₂ 93 vol.%, H₂ 7 vol.% % | N₂ 93 vol.%, H₂ 7 vol.% |
| Container dimension: outer dimension, height (mm) | | Diameter 800 × height 380 (FIG. 5) | Diameter 800 × height 380 (FIG. 5) |
| Physical properties of straight body portion | Color tone | White opaque on outer side/colorless and transparent on inner side | White opaque on outer side/colorless and transparent on inner side |
| | Total thickness (mm) | 17 | 17 |
| | Thickness of mixed silica layer (belt-like inner peripheral layer) (mm) | 7 | 7 |
| | OH group in mixed silica layer (ppm) | 600 (transparent portion) | 1100 (transparent portion) |
| | OH group in other portion than mixed silica layer (ppm) | 18 (semitransparent portion) | 18 (semitransparent portion) |
| Physical properties of bottom portion | Color tone | White opaque on outer side/colorless and transparent on inner side | White opaque on outer side/colorless and transparent on inner side |
| | Total thickness (mm) | 17 | 17 |
| | OH group (ppm) | 20 (transparent portion) | 20 (transparent portion) |
| | Thickness of high-purity silica glass layer (µm) | 0 | 0 |
| Evaluation | Melt surface vibration | ○ | ○ |
| | Multi-pulling of single crystal silicon | ○ | ○ |
| | Void and pin hole | ○ | ○ |

**[Table 8]**

| Example number | | Comparative Example 1 | Comparative Example 2 |
|---|---|---|---|
| First raw material powder | | Purity: 99.999 mass% | Purity: 99.999 mass% |
| | | Natural quartz powder Particle size: 50 to 500 µm | Natural quartz powder Particle size: 50 to 500 µm |
| Second raw material powder (crystalline silica) | | Nil | Nil |
| Second raw material powder (amorphous silica) | | Nil | Nil |
| Third raw material powder (high-purity silica) | | Nil | Synthetic cristobalite powder |
| | | | Particle size: 100 to 300 µm |
| Melting method | | Low-pressure arc discharge melting method | Normal pressure arc discharge melting method |
| Melting atmospheric gas | | N₂ 95 vol.%, H₂ 5 vol.% | N₂ 95 vol.%, H₂ 5 vol.% |
| Container dimension: outer diameter, height (mm) | | Diameter 800 × height 380 | Diameter 800 × height 380 |
| Physical properties of straight body portion | Color tone | White opaque on outer side/colorless and transparent on inner side | White opaque on outer side/colorless and transparent on inner side |
| | Thickness (mm) | 17 | 18 |
| | Width, thickness of mixed silica layer (belt-like inner peripheral layer) (mm) | Nil | Nil |
| | OH group in mixed silica layer (ppm) | - | - |
| | OH group in other portion than mixed silica layer (ppm) | 20 (transparent portion) | 40 (transparent portion) |
| Physical properties of bottom portion | Color tone | White opaque on outer side/colorless and transparent on inner side | White opaque on outer side/colorless and transparent on inner side |
| | Thickness (mm) | 17 | 18 |
| | OH group (ppm) | 20 (transparent portion) | 50 (transparent portion) |
| | Thickness of high-purity silica glass layer (µm) | 0 | (in bottom portion to straight body portion) 1000 |
| Evaluation | Melt surface vibration | Δ(first ingot) →×(second ingot) | Δ(first ingot) →×(second ingot) |
| | Multi-pulling of single crystal silicon | × | × |

**[Table 9]**

| (Unit: massppm) | |
|---|---|
| Element | Natural quartz powder (A) (First raw material powder) |
| Li | 0.1 |
| Na | 2.0 |
| K | 0.6 |
| Ca | 0.8 |
| Mg | 0.06 |
| Ti | 1.0 |
| Cr | <0.05 |
| Fe | 0.4 |
| Ni | <0.05 |
| Cu | <0.05 |
| Zn | <0.05 |
| Zr | <0.05 |
| Mo | <0.05 |
| W | <0.05 |
| Pb | <0.05 |

| (Unit: massppm) | |
|---|---|
| OH | <30 |

| (Unit: H₂O molecules/g) | |
|---|---|
| H₂O release amount | 1×10¹⁷ |

**[Table 10]**

| (Unit: massppb) | | | | | |
|---|---|---|---|---|---|
| Element | Crystalline silica powder (Natural quartz powder (B)) | Amorphous silica powder (Synthetic silica glass powder (A)) | Amorphous silica powder (Synthetic silica glass powder (B)) | Amorphous silica powder (Synthetic silica glass powder (C)) | Amorphous silica powder (Synthetic silica glass powder (D)) |
| Li | 200 | 40 | 30 | 20 | 30 |
| Na | 800 | 200 | 150 | 200 | 150 |
| K | 500 | 60 | 50 | 50 | 50 |
| Ca | 200 | 25 | 35 | 35 | 35 |
| Mg | 100 | 25 | 40 | 30 | 40 |
| Ti | 500 | 10 | 10 | 10 | 10 |
| Cr | 100 | 5 | 7 | 8 | 7 |
| Fe | 650 | 30 | 40 | 30 | 40 |
| Ni | 50 | 10 | 5 | 10 | 5 |
| Cu | 80 | 10 | 10 | 20 | 10 |
| Zn | 60 | 5 | 6 | 10 | 6 |
| Zr | 100 | <5 | <5 | <5 | <5 |
| Mo | 30 | <5 | <5 | <5 | <5 |
| W | <10 | <5 | <5 | <5 | <5 |
| Pb | <10 | <5 | <5 | <5 | <5 |

| (Unit: massppm) | | | | | |
|---|---|---|---|---|---|
| OH group | <30 | 300 | 600 | 1500 | <30 |

| (Unit: H₂O molecules/g) | | | | | |
|---|---|---|---|---|---|
| H₂O release amount | <1×10¹⁷ | 3×10¹⁷ | 7×10¹⁷ | 2×10¹⁸ | 1×10¹⁷ |

**[Table 11]**

| (Unit: massppb) | |
|---|---|
| Element | Synthetic cristobalite powder (A) |
| Li | 10 |
| Na | 50 |
| K | 20 |
| Ca | 10 |
| Mg | 10 |
| Ti | 5 |
| Cr | <5 |
| Fe | 7 |
| Ni | <5 |
| Cu | 5 |
| Zn | <5 |
| Zr | <5 |
| Mo | <5 |
| W | <5 |
| Pb | <5 |

| (Unit: massppm) | |
|---|---|
| OH group | <30 |

**[Table 12]**

| (Unit: massppb) | |
|---|---|
| Element | Crystalline silica powder (Natural quartz powder (C)) |
| Li | 70 |
| Na | 100 |
| K | 80 |
| Ca | 50 |
| Mg | 30 |
| Ti | 20 |
| Cr | 10 |
| Fe | 20 |
| Ni | 20 |
| Cu | 10 |
| Zn | 10 |
| Zr | 10 |
| Mo | <5 |
| W | <5 |
| Pb | <5 |

| (Unit: massppm) | |
|---|---|
| OH | <30 |

| (Unit: H₂O molecules/g) | |
|---|---|
| H₂O release amount | <1×10¹⁷ |

**[Table 13]**

| (Unit: massppb) | | | |
|---|---|---|---|
| Element | Amorphous silica powder (Synthetic silica glass powder (E)) | Amorphous silica powder (Synthetic silica glass powder (F)) | Amorphous silica powder (Synthetic silica glass powder (G)) |
| Li | 20 | 20 | 20 |
| Na | 100 | 90 | 80 |
| K | 30 | 30 | 30 |
| Ca | 30 | 20 | 20 |
| Mg | 20 | 20 | 30 |
| Ti | 10 | 10 | 10 |
| Cr | 5 | 5 | 5 |
| Fe | 20 | 20 | 20 |
| Ni | 5 | 5 | 5 |
| Cu | 10 | 10 | 10 |
| Zn | <5 | <5 | <5 |
| Zr | <5 | <5 | <5 |
| Mo | <5 | <5 | <5 |
| W | <5 | <5 | <5 |
| Pb | <5 | <5 | <5 |

| (Unit: massppm) | | | |
|---|---|---|---|
| OH | 300 | 800 | 1600 |

| (Unit: H₂O molecules/g) | | | |
|---|---|---|---|
| H₂O release amount | 3×10¹⁷ | 8×10¹⁷ | 2×10¹⁸ |

As can be understood from Tables 1 to 13, in Examples 1 to 14, the melt surface vibration was successfully suppressed at the time of pulling the single crystal silicon, and the multi-pulling was smoothly carried out. Further, in Examples 11 to 14, it was understood that, since the mixed silica layer 53 was formed on the curved portion 62 in addition to the straight body portion 61, even though the rough surface is produced on the inner surface at the time of pulling the single crystal silicon, void defects called voids or pin holes were hardly introduced in the single crystal silicon. Furthermore, in Examples 11 to 14, the melt surface vibration of the silicon melt was stably suppressed even in stages following the initial stages of pulling the single crystal silicon.

### (Example 15)

Based on the steps (2-a) to (2-e) shown in FIG. 16, a silica container 77 for pulling single crystal silicon depicted in FIG. 14 was manufactured. As a first raw material powder 11, natural quartz powder (a) having a particle size of 50 to 500 µm and purity of 99.999 mass% was prepared. Impurity concentration of this natural quartz powder (a) is shown in Table 19. As a second raw material powder 12, a mixed powder of a crystalline silica powder 13 as natural quartz powder (b) and an amorphous silica powder 14 as synthetic silica glass powder (a) was prepared. The amorphous silica powder 14 is a synthetic silica glass powder prepared by the oxyhydrogen flame hydrolysis method of silicon tetrachloride SiCl₄. Impurity element concentration, OH group concentration, and an H₂O molecule release amount of each of the natural quartz powder (b) and the synthetic silica glass powder (a) are shown in Table 20 and Table 21. A mixing ratio of the crystalline silica powder 13 and the amorphous silica powder 14 was set to 40:60 (mass% ratio).

The first raw material powder 11 and the second raw material powder 12 were put into a graphite mold 101 shown in FIG. 4, FIG. 17, and FIG. 18 while rotating the graphite mold 101, thereby providing a second temporary compact 43. Subsequently, with the use of the apparatus shown in FIG. 19 and FIG. 20, a dried mixed gas containing 95 vol% of N₂ and 5 vol% of H₂ was used as the inner atmosphere of the second temporary compact 43, electric discharge heating and melting was performed in the second temporary compact 43 while effecting aspiration and decompression from an outer peripheral portion, thereby producing a silica container 73. A bottom portion silica glass layer 55 was formed on a bottom portion of this silica container 73 with the use of a melting atmospheric gas containing 95 vol% of N₂ and 5 vol% of H₂, thereby manufacturing a silica container 74 shown in FIG. 14. As a raw material powder (third raw material powder 22) for the bottom portion silica glass layer 55 in this case, synthetic cristobalite powder (a) having impurity concentration, OH group concentration, and an H₂O molecule release amount shown in Table 22 was used.

### (Example 16)

A silica container 74 shown in FIG. 14 was manufactured. Manufacturing conditions are the same as those in Example 15 except that a mixing ratio of the crystalline silica powder (natural quartz powder (b)) and the amorphous silica powder (synthetic silica glass powder (a)) was set to 60:40 (a mass ratio), a melting atmospheric gas containing 50 vol.% of N₂, 10 vol.% of H₂, and 40 vol.% of He was used, and a bottom portion silica glass layer 55 was formed with a larger thickness than that in Example 15.

### (Example 17)

A silica container 74 shown in FIG. 14 was manufactured. Manufacturing conditions are the same as those in Example 15 except that a mixing ratio of the crystalline silica powder (natural quartz powder (b) and the amorphous silica powder (synthetic silica glass powder (a)) was set to 80:20 (a mass ratio) and a bottom portion silica glass layer 55 was formed with a larger thickness than that in Example 15.

### (Example 18)

A silica container 74 shown in FIG. 15, i.e., a silica container 74 having a mixed silica layer 53 formed to reach an upper end of an inner surface layer was manufactured. Other manufacturing conditions are the same as those in Example 15 except that synthetic silica glass power (b) shown in Table 21 was used as an amorphous silica powder 14, a melting atmospheric gas was set to contain 90 vo.% of N₂ and 10 vol.% of H₂, and a bottom portion silica glass layer 55 was formed with a larger thickness than that in Example 15.

### (Example 19)

Although a silica container 74 shown in FIG. 15 was manufactured by the same method as Example 18, a mixing ratio of the crystalline silica powder (natural quartz powder (b)) and the amorphous silica powder (synthetic silica glass powder (b)) was set to 60:40, and a melting atmospheric gas was set to contain 95 vol.% of N₂ and 5 vol.% of H₂.

### (Example 20)

Although a silica container 74 shown in FIG. 15 was manufactured by the same method as Example 19, a mixing ratio of the crystalline silica powder (natural quartz powder (b)) and the amorphous silica powder (synthetic silica glass powder (b)) was set to 80:20.

### (Comparative Example 3)

A silica container 91 shown in FIG. 22 was manufactured with the use of a natural quartz powder as a raw material powder by a low-pressure arc discharge melting method. The silica container 91 does not have a portion corresponding to the mixed silica layer 53 according to the present invention, a container outer side thereof is made of opaque silica glass 81 containing bubbles, and a container inner side 82 thereof is made of transparent silica glass.

### (Comparative Example 4)

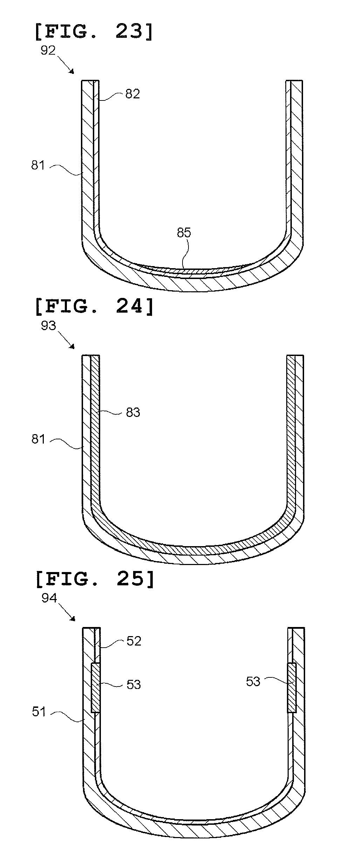

A silica container 92 shown in FIG. 23 was manufactured. First, a silica container in which a container outer side is made of opaque silica glass 81 containing bubbles and a container inner side 82 is made of transparent silica glass was prepared by using a natural quartz powder as a raw material powder based on the normal pressure arc discharge melting method, and a bottom portion silica glass layer 85 was formed on a bottom portion of this silica container by using a synthetic cristobalite powder as a raw material.

### (Comparative Example 5)

A silica container 93 that is shown in FIG. 24 and has a mixed silica layer 83 on an entire container inner surface and an outer side made of opaque silica glass 81 was manufactured. That is, the silica container 93 has the same configuration as each of Examples 18 to 20 except that a bottom portion silica glass layer is not formed. A specific manufacturing method is the same as Example 19 except that the bottom portion silica glass layer is not formed and synthetic silica glass powder (a) is used as an amorphous silica powder.

### (Example 21)

A silica container 94 shown in FIG. 25 was manufactured. The silica container 94 was manufactured in the same manner as Example 15 except that a mixing ratio of the crystalline silica powder (natural quartz powder (b)) and the amorphous silica powder (synthetic quartz glass powder) was set to 50:50 (a mass% ratio), a mixed silica layer 53 was formed with a thickness of 2 mm in a straight body portion alone (a height (a width) in the straight body portion was set to 150 mm), and a bottom portion silica glass layer 55 was not formed.

### [Evaluation Method in Examples and Comparative Examples]

Physical properties and characteristics of the raw material powder used in each of Examples 15 to 21 and Comparative Examples 3 to 5 and the silica container manufactured in them were evaluated as follows.

A particle size of each raw material powder was measured as described above, and each result is shown in Tables 14 to 18.

Measurement of a layer thickness of the silica container, measurement of OH group concentration, analysis of impurity metal element concentration, and a method for measuring an H₂O gas release amount were carried out in the same manner as that described above.

### Evaluation of Melt Surface Vibration when Pulling Single Crystal Silicon:

Metal polysilicon having purity of 99.99999999 mass% was put into a silica container having a diameter of 800 mm (32 inches), and a temperature was raised to provide a silicon melt. At this time, in Examples 15 to 17, a molten silicon surface was set to be present near an upper end of the mixed silica layer of the silica container. An argon (Ar) gas 100% atmosphere was formed in a CZ apparatus, a seed crystal of single crystal silicon was moved down while rotating, and seeding, necking, shouldering, pulling, and tailing were sequentially advanced. The evaluation of degrees of the melt surface vibration were as follows. A symbol before an arrow represents evaluation at the time of pulling the single crystal silicon for the first time, and a symbol after the arrow represents evaluation at the time of pulling the single crystal silicon for the second time.
- Melt surface vibration did not occur, and seeding, necking, shouldering, pulling, and tailing were all smoothly performed. ○ (good)
- Melt surface vibration slightly occurred, but shouldering, pulling, and tailing were eventually performed by repeating steps of seeding and necking more than once. Δ (slightly good)
- Melt surface vibration was intensive, and seeding, necking, and shouldering were not able to be performed. × (bad)

Evaluation of continuous pulling of the single crystal silicon and evaluation of voids and pin holes were conducted in the same manner as that described above.

Manufacturing conditions, measured physical property values, and evaluation results of the respective silica containers manufactured in Examples 15 to 20, Comparative Examples 3 to 5, and Example 21 were organized and shown in the following Tables 14 to 22.

**[Table 14]**

| Example number | | Example 15 | Example 16 |
|---|---|---|---|
| First raw material powder | | Purity: 99.999 mass% | Purity: 99.999 mass% |
| | | Natural quartz powder(a) | Natural quartz powder(a) |
| | | Particle size: 50 to 500 µm | Particle size: 50 to 500 µm |
| Second raw material powder (crystalline silica) | | Natural quartz powder(b) 40 mass% | Natural quartz powder(b) 60 mass% |
| | | Particle size: 500 to 1000 µm | Particle size: 500 to 1000 µm |
| Second raw material powder (amorphous silica) | | Synthetic silica glass powder (a) 60 mass% | Synthetic silica glass powder (a) 40 mass% |
| | | Particle size: 500 to 1000 µm | Particle size: 500 to 1000 µm |
| Third raw material powder (high-purity silica) | | Synthetic cristobalite powder (a) | Synthetic cristobalite powder (a) |
| | | Particle size: 100 to 300 µm | Particle size: 100 to 300 µm |
| Melting method | | Low-pressure arc discharge melting method | Low-pressure arc discharge melting method |
| Melting atmospheric gas | | N₂ 95 vol.%, H₂ 5 vol.% % | N₂ 50vol.%, H₂ 10 vol.%, He 40 vol.% |
| Container dimension: outer diameter, height (mm) | | Diameter 800 × height 380 (FIG. 1) | Diameter 800 × height 380 (FIG. 1) |
| Physical properties of straight body portion | Color tone | White opaque on outer side/colorless and transparent on inner side | White opaque on outer side/colorless and transparent on inner side |
| | Total thickness (mm) | 17 | 17 |
| | Thickness of mixed silica layer (mm) | 7 | 7 |
| | OH group in mixed silica layer (ppm) | 180 (transparent portion) | 120 (transparent portion) |
| | OH group in other portion than mixed silica layer (container outer side) (ppm) | 16 (semitransparent portion) | 10 (semitransparent portion) |
| Physical properties of bottom portion | Color tone | White opaque on outer side/colorless and transparent on inner side | White opaque on outer side/colorless and transparent on inner side |
| | Total thickness (mm) | 18 | 19 |
| | OH group (ppm) | 15 (transparent portion) | 8 (transparent portion) |
| | Thickness of bottom portion silica glass layer (µm) | 700 (maximum value) | 1400 (maximum value) |
| Evaluation | Melt surface vibration | ○ | ○ |
| | Multi-pulling of single crystal silicon | ○ | ○ |
| | Void and pin hole | ○ | ○ |

**[Table 15]**

| Example number | | Example 17 | Example 18 |
|---|---|---|---|
| First raw material powder | | Purity: 99.999 mass% | Purity: 99.999 mass% |
| | | Natural quartz powder (a) | Natural quartz powder (a) |
| | | Particle size: 50 to 500 µm | Particle size: 50 to 500 µm |
| Second raw material powder (crystalline silica) | | Natural quartz powder (b) 80 mass% | Natural quartz powder (b) 40 mass% |
| | | Particle size: 500 to 1000 µm | Particle size: 500 to 1000 µm |
| Second raw material powder (amorphous silica) | | Synthetic silica glass powder (a) 20 mass% | Synthetic silica glass powder (b) 60 mass% |
| | | Particle size: 500 to 1000 µm | Particle size: 500 to 1000 µm |
| Third raw material powder (high-purity silica) | | Synthetic cristobalite powder (a) | Synthetic cristobalite powder (a) |
| | | Particle size: 100 to 300 µm | Particle size: 100 to 300 µm |
| Melting method | | Low-pressure arc discharge melting method | Low-pressure arc discharge melting method |
| Melting atmospheric gas | | N₂ 95 vol.%, H₂ 5 vol.% | N₂ 90vol.%, H₂ 10 vol.% |
| Container dimension: outer diameter, height (mm) | | Diameter 800 × height 380 (FIG. 1) | Diameter 800 × height 380 (FIG. 2) |
| Physical properties of straight body portion | Color tone | White opaque on outer side/colorless and transparent on inner side | White opaque on outer side/colorless and transparent on inner side |
| | Total thickness (mm) | 17 | 17 |
| | Thickness of mixed silica layer (mm) | 7 | 7 |
| | OH group in mixed silica layer (ppm) | 60 (transparent portion) | 700 (transparent portion) |
| | OH group in other portion than mixed silica layer (container outer side) (ppm) | 15 (semitransparent portion) | 30 (semitransparent portion) |
| Physical properties of bottom portion | Color tone | White opaque on outer side/colorless and transparent on inner side | White opaque on outer side/colorless and transparent on inner side |
| | Total thickness (mm) | 19 | 19 |
| | OH group (ppm) | 15 (transparent portion) | 25 (transparent portion) |
| | Thickness of bottom portion silica glass layer (µm) | 2000 (maximum value) | 1500 (maximum value) |
| Evaluation | Melt surface vibration | ○ | ○ |
| | Multi-pulling of single crystal silicon | ○ | ○ |
| | Void and pin hole | ○ | ○ |

**[Table 16]**

| Example number | | Example 19 | Example 20 |
|---|---|---|---|
| First raw material powder | | Purity: 99.999 mass% | Purity: 99.999 mass% |
| | | Natural quartz powder (a) | Natural quartz powder (a) |
| | | Particle size: 50 to 500 µm | Particle size: 50 to 500 µm |
| Second raw material powder (crystalline silica) | | Natural quartz powder (b) 60 mass% | Natural quartz powder (b) 80 mass% |
| | | Particle size: 500 to 1000 µm | Particle size: 500 to 1000 µm |
| Second raw material powder (amorphous silica) | | Synthetic silica glass powder (b) 40 mass% | Synthetic silica glass powder (b) 20 mass% |
| | | Particle size: 500 to 1000 µm | Particle size: 500 to 1000 µm |
| Third raw material powder (high-purity silica) | | Synthetic cristobalite powder (a) | Synthetic cristobalite powder (a) |
| | | Particle size: 100 to 300 µm | Particle size: 100 to 300 µm |
| Melting method | | Low-pressure arc discharge melting method | Low-pressure arc discharge melting method |
| Melting atmospheric gas | | N₂ 95 vol.%, H₂ 5 vol.% | N₂ 95 vol.%, H₂ 5 vol.% |
| Container dimension: outer diameter, height (mm) | | Diameter 800 × height 380 (FIG. 2) | Diameter 800 × height 380 (FIG. 2) |
| Physical properties of straight body portion | Color tone | White opaque on outer side/colorless and transparent on inner side | White opaque on outer side/colorless and transparent on inner side |
| | Total thickness (mm) | 17 | 17 |
| | Thickness of mixed silica layer (mm) | 7 | 7 |
| | OH group in mixed silica layer (ppm) | 450 (transparent portion) | 240 (transparent portion) |
| | OH group in other portion than mixed silica layer (container outer side) (ppm) | 20 (semitransparent portion) | 20 (semitransparent portion) |
| Physical properties of bottom portion | Color tone | White opaque on outer side/colorless and transparent on inner side | White opaque on outer side/colorless and transparent on inner side |
| | Total thickness (mm) | 19 | 19 |
| | OH group (ppm) | 18 (transparent portion) | 20 (transparent portion) |
| | Thickness of bottom portion silica glass layer (µm) | 1500 (maximum value) | 1500 (maximum value) |
| Evaluation | Melt surface vibration | ○ | ○ |
| | Multi-pulling of single crystal silicon | ○ | ○ |
| | Void and pin hole | ○ | ○ |

**[Table 17]**

| Example number | | Comparative Example 3 | Comparative Example 4 |
|---|---|---|---|
| First raw material powder | | Purity: 99.999 mass% | Purity: 99.999 mass% |
| | | Natural quartz powder (a) | Natural quartz powder (a) |
| | | Particle size: 50 to 500 µm | Particle size: 50 to 500 µm |
| Second raw material powder (crystalline silica) | | Nil | Nil |
| Second raw material powder (amorphous silica) | | Nil | Nil |
| Third raw material powder (high-purity silica) | | Nil | Synthetic cristobalite powder |
| | | | Particle size: 100 to 300 µm |
| Melting method | | Low-pressure arc discharge melting method | Normal pressure arc discharge melting method |
| Melting atmospheric gas | | N₂ 95 vol.%, H₂ 5 vol.% | N₂ 95 vol.%, H₂ 5 vol.% |
| Container dimension: outer diameter, height (mm) | | Diameter 800 × height 380 (FIG. 11) | Diameter 800 × height 380 (FIG. 12) |
| Physical properties of straight body portion | Color tone | White opaque on outer side/colorless and transparent on inner side | White opaque on outer side/colorless and transparent on inner side |
| | Total thickness (mm) | 17 | 17 |
| | Thickness of mixed silica layer (mm) | Nil | Nil |
| | OH group in mixed silica layer (ppm) | - | - |
| | OH group in other portion than mixed silica layer (ppm) | 30(semitransparent portion) | 50(semitransparent portion) |
| Physical properties of bottom portion | Color tone | White opaque on outer side/colorless and transparent on inner side | White opaque on outer side/colorless and transparent on inner side |
| | Total thickness (mm) | 17 | 19 |
| | OH group (ppm) | 30(transparent portion) | 60(transparent portion) |
| | Thickness of high-purity silica glass layer (µm) | 0 | 1900(maximum value) |
| Evaluation | Melt surface vibration | Δ→× | Δ→× |
| | Multi-pulling of single crystal silicon | × | × |
| | Void and pin hole | Δ | ○ |

**[Table 18]**

| Example number | | Comparative Example 5 | Example 21 |
|---|---|---|---|
| First raw material powder | | Purity: 99.999 mass% | Purity: 99.999 mass% |
| | | Natural quartz powder (a) | Natural quartz powder (a) |
| | | Particle size: 50 to 500 µm | Particle size 50 to 500 µm |
| Second raw material powder (crystalline silica) | | Natural quartz powder (b) 60 mass% | Natural quartz powder (b) 50 mass% |
| | | Diameter: 500 to 1000 µm | Diameter: 500 to 1000 µm |
| Second raw material powder (amorphous silica) | | Synthetic silica glass powder (a) 40 mass% | Synthetic silica glass powder (a) 50 mass% |
| | | Diameter: 500 to 1000 µm | Diameter: 500 to 1000 µm |
| Third raw material powder (high-purity silica) | | Nil | Nil |
| Melting method | | Low-pressure arc discharge melting method | Low-pressure arc discharge melting method |
| Melting atmospheric gas | | N₂ 95 vol.%, H₂ 5 vol.% | N₂ 95 vol.%, H₂ 5 vol.% |
| Container dimension: outer diameter, height (mm) | | Diameter 800 × height 380 (FIG. 13) | Diameter 800 × height 380 (FIG. 14) |
| Physical properties of straight body portion | Color tone | White opaque on outer side/colorless and transparent on inner side | White opaque on outer side/colorless and transparent on inner side |
| | Total thickness (mm) | 17 | 17 |
| | Thickness of mixed silica layer (mm) | 7 | 2 (width is 150 mm) |
| | OH group in mixed silica layer (ppm) | 120 | 120 |
| | OH group in other portion than mixed silica layer (ppm) | 30(semitransparent portion) | 30(semitransparent portion) |
| Physical properties of bottom portion | Color tone | White opaque on outer side/colorless and transparent on inner side | White opaque on outer side/colorless and transparent on inner side |
| | Total thickness (mm) | 17 | 17 |
| | OH group (ppm) | 20 | 20 |
| | Thickness of high-purity silica glass layer (µm) | 0 | 0 |
| Evaluation | Melt surface vibration | ○ | ○→Δ |
| | Multi-pulling of single crystal silicon | ○ | Δ |
| | Void and pin hole | × | Δ |

**[Table 19]**

| (massppm) | |
|---|---|
| Element | Natural quartz powder (a) (first raw material powder) |
| Li | 0.1 |
| Na | 2.0 |
| K | 0.6 |
| Ca | 0.8 |
| Mg | 0.06 |
| Ti | 1.0 |
| Cr | <0.05 |
| Fe | 0.4 |
| Ni | <0.05 |
| Cu | <0.05 |
| Zn | <0.05 |
| Zr | <0.05 |
| Mo | <0.05 |
| W | <0.05 |
| Pb | <0.05 |

| (massppm) | |
|---|---|
| OH | <30 |

| (H₂O molecules/g) | |
|---|---|
| H₂O release amount | 1×10¹⁷ |

**[Table 20]**

| (Unit: massppb) | |
|---|---|
| Element | Crystalline silica powder (Natural quartz powder (b)) |
| Li | 60 |
| Na | 90 |
| K | 80 |
| Ca | 30 |
| Mg | 20 |
| Ti | 20 |
| Cr | 10 |
| Fe | 15 |
| Ni | 10 |
| Cu | 10 |
| Zn | <5 |
| Zr | <5 |
| Mo | <5 |
| W | <5 |
| Pb | <5 |

| (Unit: massppm) | |
|---|---|
| OH | <30 |

| (Unit: H₂O molecules/g) | |
|---|---|
| H₂O release amount | <1×10¹⁷ |

**[Table 21]**

| (Unit: massppb) | | |
|---|---|---|
| Element | Amorphous silica powder (synthetic silica glass powder (a)) | Amorphous silica powder (synthetic silica glass powder (b)) |
| Li | 20 | 20 |
| Na | 90 | 80 |
| K | 50 | 60 |
| Ca | 40 | 30 |
| Mg | 20 | 10 |
| Ti | 10 | 5 |
| Cr | 5 | 10 |
| Fe | 15 | 15 |
| Ni | 5 | 5 |
| Cu | 10 | 5 |
| Zn | <5 | <5 |
| Zr | <5 | <5 |
| Mo | <5 | <5 |
| W | <5 | <5 |
| Pb | <5 | <5 |

| (Unit: massppm) | | |
|---|---|---|
| OH | 310 | 1200 |

| (Unit: H₂O molecules/g) | | |
|---|---|---|
| H₂O release amount | 3×10¹⁷ | 1×10¹⁸ |

**[Table 22]**

| (massppb) | |
|---|---|
| Element | Synthetic cristobalite powder (a) |
| Li | 20 |
| Na | 50 |
| K | 20 |
| Ca | 20 |
| Mg | 15 |
| Ti | 10 |
| Cr | 10 |
| Fe | 10 |
| Ni | 7 |
| Cu | 6 |
| Zn | <5 |
| Zr | <5 |
| Mo | <5 |
| W | <5 |
| Pb | <5 |

| (massppm) | |
|---|---|
| OH | <30 |

| (Unit: H₂O molecules/g) | |
|---|---|
| H₂O release amount | <1×10¹⁷ |

As can be understood from Tables 14 to 22, in Examples 15 to 16, the melt surface vibration was successfully suppressed at the time of pulling the single crystal silicon, and the multi-pulling was smoothly carried out. Further, in Examples 15 to 16, void defects called voids or pin holes were hardly introduced into the single crystal silicon. In Comparative Examples 3 and 4, the melt surface vibration occurred, and the intensive vibration occurred from the initial stage of the pulling step in particular. In Example 21, likewise, the melt surface vibration occurred from the pulling step of the second single crystal silicon in particular.

In Comparative Example 5, the melt surface vibration hardly occurred, but the evaluation of voids and pin holes was very poor.

It is to be noted that the present invention is not restricted to the foregoing embodiments. The foregoing embodiments are just illustrative examples, and any example that has substantially the same configuration and exercises the same functions and effects as the technical concept described in claims of the present invention is included in the technical scope of the present invention.

## Claims

1. A method for manufacturing a silica container for pulling single crystal silicon, the silica container having a straight body portion, a curved portion, and a bottom portion, the method comprising:
a step of preparing a crystalline silica powder having a particle size of 10 to 1000 µm as a first raw material powder;
a step of preparing a mixed powder of a crystalline silica powder having a particle size of 50 to 2000 µm and an amorphous silica powder having a particle size of 50 to 2000 µm as a second raw material powder;
a step of putting the first raw material powder to an inner side of a mold having rotation symmetry, and temporarily molding the first raw material powder into a predetermined shape corresponding to an inner wall of the mold while rotating the mold to form a first temporary compact made of the first raw material powder in the mold;
a step of putting the second raw material powder to at least one of an inner side and an upper portion of the first temporary compact formed in the mold to form a second temporary compact having a portion made of the first raw material powder and a portion made of the second raw material powder into a shape corresponding to a shape of a silica container to be manufactured, the second temporary compact having a portion made of the second raw material powder at a position corresponding to at least an inner surface layer portion of the straight body portion of the silica container to be manufactured; and
a step of performing heating from an inner side of the second temporary compact based on an electric discharge heating and melting method while rotating the mold to form the portion made of the second raw material powder in the second temporary compact into a mixed silica layer in which a phase in which the crystalline silica powder is fused and a phase in which the amorphous silica powder is fused are mixed in a granular texture, an outer side of the container being made of opaque silica glass containing bubbles, an inner side of the container being made of transparent glass.

2. The method for manufacturing a silica container for pulling single crystal silicon according to claim 1, wherein the mixed silica layer is formed to include a position on an inner surface corresponding to a melt surface on the initial stage when the silica container holds a raw material silicon melt in the inner surface of the silica container to be manufactured.

3. The method for manufacturing a silica container for pulling single crystal silicon according to claim 1 or 2, wherein the second temporary compact is formed with the portion made of the second raw material powder at a position corresponding to the inner surface layer portion of the straight body portion and the curved portion of the silica container to be manufactured.

4. The method for manufacturing a silica container for pulling single crystal silicon according to any one of claims 1 to 3, wherein the mixed silica layer is formed with a thickness of 2 mm or more in a wall thickness direction of the silica container and a width of 100 mm or more.

5. A method for manufacturing a silica container for pulling single crystal silicon comprising, after manufacturing the silica container based on the method according to any one of claims 1 to 4, a step of forming a high-purity silica glass layer in which concentration of each of impurity elements Li, Na, and K is 50 massppb or less, concentration of each of impurity elements Ca and Mg is 25 massppb or less, and concentration of each of impurity elements Ti, Cr, Fe, Ni, Cu, Zn, Zr, Mo, W, and Pb is 10 massppb or less and which has a thickness of 200 to 2000 µm on at least part of an inner surface where the mixed silica layer is not formed in the inner surface of the silica container.

6. The method for manufacturing a silica container for pulling single crystal silicon according to claim 1,
wherein, at the step of forming the second temporary compact, the second raw material powder is put to the inner side of the first temporary compact, and the second temporary compact is formed with the portion made of the second raw material powder at a position corresponding to the inner surface layer portion of the straight body portion, the curved portion, and the bottom portion of the silica container to be manufactured,
the method further comprises a step of preparing an amorphous silica powder having a particle size of 10 to 1000 µm as a third raw material powder, and
the method further comprises, after manufacturing the silica container by performing heating based on the electric discharge heating and melting method, a step of performing melting based on the electric discharge heating and melting method while spreading the third raw material powder from the upper side of the silica container, allowing the molten third raw material powder to adhere to an inner surface portion of the bottom portion, and thereby forming a bottom portion silica glass layer.

7. The method for manufacturing a silica container for pulling single crystal silicon according claim 6, wherein the mixed silica layer is formed with a thickness of 2 mm or more in a wall thickness direction of the silica container.

8. The method for manufacturing a silica container for pulling single crystal silicon according to any one of claims 1 to 7, wherein, in the second raw material powder, OH group concentration of the crystalline silica powder is 50 massppm or less, and OH group concentration of the amorphous silica powder is 200 to 2000 ppm.

9. A silica container for pulling single crystal silicon, the container having a straight body portion, a curved portion, and a bottom portion,
wherein an outer side of the container is made of opaque silica glass containing bubbles, and an inner side of the container is made of transparent silica glass, and
a mixed silica layer in which a phase in which a crystalline silica powder is fused and a phase in which an amorphous silica powder is fused are mixed in a granular texture is provided on at least an inner surface layer portion of the straight body portion.

10. The silica container for pulling single crystal silicon according to claim 9, wherein the mixed silica layer is formed to include a position on an inner surface corresponding to a melt surface on the initial stage when the silica container holds a raw material silicon melt in the inner surface of the silica container.

11. The silica container for pulling single crystal silicon according to claim 9 or 10, wherein the mixed silica layer is provided on the inner surface layer portion of the straight body portion and the curved portion.

12. The silica container for pulling single crystal silicon according to any one of claims 9 to 11, wherein the mixed silica layer has a thickness of 2 mm or more in a wall thickness direction of the silica layer and a width of 100 mm or more.

13. The silica container for pulling single crystal silicon according to any one of claims 9 to 12, wherein a high-purity silica glass layer in which concentration of each of impurity elements Li, Na, and K is 50 massppb or less, concentration of each of impurity elements Ca and Mg is 25 massppb or less, and concentration of each of impurity elements Ti, Cr, Fe, Ni, Cu, Zn, Zr, Mo, W, and Pb is 10 massppb or less and which has a thickness of 200 to 2000 µm is provided on at least part of an inner surface where the mixed silica layer is not formed in the inner surface of the silica container.

14. The silica container for pulling single crystal silicon according to claim 9,
wherein the mixed silica layer is provided on the inner surface layer portion of the straight body portion, the curved portion, and the bottom portion, and
a bottom portion silica glass layer is provided on an inner surface of the mixed silica layer on the bottom portion.

15. The silica container for pulling single crystal silicon according to any one of claims 9 to 14, wherein the mixed silica layer is formed by using a mixed powder of a crystalline silica powder having OH group concentration of 50 massppm or less and an amorphous silica powder having OH group concentration of 200 to 2000 ppm as a raw material.
